Europäisches Patentamt

European Patent Office

Office européen des brevets

(19)

(11) **EP 0 604 093 B1**

(12) **EUROPEAN PATENT SPECIFICATION**

(45) Date of publication and mention
of the grant of the patent:
**19.11.1997 Bulletin 1997/47**

(51) Int Cl.⁶: **G02B 17/08**, G03F 7/20

(21) Application number: **93310039.8**

(22) Date of filing: **13.12.1993**

(54) **Catadioptric reduction projection optical system**

Verkleinerndes katadioptrisches Projektionssystem

Système de projection de réduction catadioptrique

(84) Designated Contracting States:
**DE FR GB**

(30) Priority: **24.12.1992 JP 343976/92**

(43) Date of publication of application:
**29.06.1994 Bulletin 1994/26**

(73) Proprietor: **NIKON CORPORATION
Tokyo (JP)**

(72) Inventors:
• **Ishiyama, Toshiro
  Shinagawa-ku, Tokyo (JP)**
• **Shimizu, Yoshiyuki, Miurakaiganhaitsu, 4-415
  Miura-shi, Kanagawa-ken (JP)**
• **Hayashi, Kiyoshi
  Koganei-shi, Tokyo (JP)**

(74) Representative: **Burke, Steven David et al
R.G.C. Jenkins & Co.
26 Caxton Street
London SW1H 0RJ (GB)**

(56) References cited:
**EP-A- 0 271 737          EP-A- 0 350 955
EP-A- 0 527 043          US-A- 4 685 777
US-A- 4 812 028**

**Description**

BACKGROUND OF THE INVENTION

Field of the Invention

The present invention relates to a catadioptric optical system and, more particularly, to an imaging optical system for performing reduction projection.

Related Background Art

Various optical systems for projecting and exposing a mask pattern onto a photoresist on a wafer to manufacture an integrated circuit such as an LSI have been proposed. It is known that an aberration is well corrected at a relatively large aperture in a Dyson type catadioptric optical system. However, since the imaging magnification in the Dyson type catadioptric system is unity, there is a limit in the transfer of a fine pattern.

As an optical system having a reduction factor suitable for the manufacture of a semiconductor device having a finer pattern, an optical system which is a modification of the Dyson type catadioptric optical system is disclosed in U. S. Patent 4,747,678 and U.S. Patent 4,953,960.

Although the optical system disclosed in U.S. Patent 4,747,678 which permits reduction projection allows imaging in a reduction scale having a ring-shaped view field, it basically has three concave mirrors and a convex mirror, and must be combined with a number of lenses in the use of an exposure apparatus for microlithography, resulting in a very complicated optical construction.

The reduction optical system disclosed in U.S. Patent 4,953,960 comprises a combination of a concave mirror and a lens system. Since this optical system attains reduction mainly using the concave mirror, the aberration is large, and a number of lenses must be combined to correct the aberrations.

EP-A-527,043, which is prior art only by virtue of Article 54(3) EPC, describes a catadioptric reduction projection optical system comprising a first sub-system including, in succession from the object side, a first lens group of positive refractive power and a first concave reflection mirror for forming a primary image of an object, a second optical sub-system including, in succession from the object side, a second concave reflection mirror and a third lens group of positive refractive power for re-imaging the primary image, and a second lens group of positive refractive power arranged in an optical path between the first concave reflection mirror and the second concave reflection mirror.

SUMMARY OF THE INVENTION

It would be desirable to provide a catadioptric reduction projection optical system, which has an excellent imaging performance as an optical system used in the manufacture of a semiconductor device, and has a large numerical aperture.

In accordance with the present invention there is provided a catadioptric reduction projection optical system comprising:

a first sub-system for forming a primary image $I_1$ of an object and including, in succession from an object side, a first lens group $G_1$ of positive refractive power and a first concave reflection mirror $M_1$, and
a second sub-system for re-imaging the primary image and including, in succession from the object side, a second lens group $G_2$ of positive or negative refractive power, a second concave reflection mirror $M_2$ and a third lens group $G_3$ of positive refractive power, and

wherein a magnification $\beta_{G3}$ of said third lens group $G_3$ satisfies:

$$0.05 < \beta_{G3} < 0.6,$$

and
wherein a magnification $\beta_{M1}$ of said first concave reflection mirror $M_1$ satisfies:

$$\beta_{M1} < -0.7.$$

In the catadioptric reduction projection optical system according to the present invention with the above construction, the first and second partial optical systems each have a concave reflection mirror having chief refractive power and a lens group (first or third lens group $G_1$ or $G_3$) of positive refractive power, and both make reduction imaging possible. Therefore, a predetermined reduction factor can be obtained as a whole system without forcing each partial optical system to bear a great burden in aberration correction. For this reason, it is possible to simplify the optical construction and yet maintain an excellent imaging performance.

A catadioptric reduction projection optical system according to one embodiment of the present invention comprises: a first partial optical system including, in succession from the object side, a first lens group $G_1$ of positive refractive power and a first concave reflection mirror $M_1$, and for forming a primary image of an object; and a second partial optical system including, in succession from the object side, a second concave reflection mirror $M_2$ and a third lens group $G_3$ of positive refractive power, and for re-imaging the primary image, wherein a second lens group $G_2$ of positive or negative refractive power is arranged in an optical path between the first and second concave reflection mirrors $M_1$ and $M_2$, and at least one of the first to third lens groups $G_1$ to $G_3$ is constituted by at least two different glass materials. Thus, chromatic aberration is corrected satisfactorily, and the imaging performance can be further improved.

The catadioptric reduction projection optical system according to the present invention satisfies:

$$0.05 < \beta_{G3} < 0.6 \qquad (1)$$

where $\beta_{G3}$ is the magnification of the third lens group $G_3$ of positive refractive power. This condition defines a proper magnification of the third lens group $G_3$, and allows to realize a catadioptric reduction projection optical system having an excellent optical performance, and to obtain a physically constructible catadioptric reduction projection optical system. The physically constructible optical system means an optical system in which optical members do not interfere with each other in an arrangement of optical members constituting the catadioptric reduction projection optical system.

When $\beta_{G3}$ exceeds the upper limit of the above-mentioned condition (1), a light beam propagating between the concave reflection mirrors $M_1$ and $M_2$ considerably overlaps a light beam propagating from the concave reflection mirror $M_2$ to the secondary image surface, and the arrangement of optical members constituting the catadioptric reduction projection optical system cannot be realized.

When $\beta_{G3}$ is set below the lower limit of the above-mentioned condition (1), the refractive power of the third lens group $G_3$ increases, and coma and chromatic aberration are generated considerably.

The catadioptric reduction projection optical system according to the present invention satisfies:

$$\beta_{M1} < -0.7 \qquad (2)$$

where $\beta_{M1}$ is the magnification of the first concave reflection mirror $M_1$. This condition defines a proper magnification of the first concave reflection mirror $M_1$. When $\beta_{M1}$ exceeds the upper limit of the condition (2), the refractive power of the first concave reflection mirror $M_1$ increases, and aberrations, especially, spherical aberration and coma, generated by the first concave reflection mirror $M_1$ increase. In order to cancel these aberrations, the negative refractive power of a refracting optical system must be strengthened, and it becomes difficult to satisfactorily correct these aberrations.

Conversely, $\beta_{M1}$ preferably satisfies the condition $-2.0 < \beta_{M1}$. When $\beta_{M1}$ is set below -2.0, the refractive power of the refracting optical power must be strengthened to compensate for a decrease in refractive power of the concave reflection mirror $M_1$. At this time, the merits of a reflecting optical system are lost, the construction of the refracting optical system is more complicated, and it also becomes difficult to attain aberration correction.

The catadioptric reduction projection optical system according to the present invention preferably satisfies:

$$-2.5 < \beta_{M2} < -0.7 \qquad (3)$$

where $\beta_{M2}$ is the magnification of the second concave reflection mirror $M_2$. This condition (3) defines a proper magnification of the second reflection mirror $M_2$. When $\beta_{M2}$ exceeds the upper limit of the condition (3), the refractive power of the concave reflection mirror $M_2$ increases, and aberrations, especially, spherical aberration and coma, generated by the this concave reflection mirror $M_2$ increase. As a result, it becomes difficult to satisfactorily correct the aberrations. Furthermore, a light beam propagating toward the concave reflection mirror $M_2$ considerably overlaps a light beam propagating from the concave reflection mirror $M_2$ toward the secondary image surface, and it becomes difficult to obtain a physically constructible optical system.

When $\beta_{M2}$ is set below the lower limit of the condition, the refractive power of the concave reflection mirror $M_2$ decreases, and the refracting optical system must compensate for the decrease in refractive power, thus losing merits of the reflecting optical system. At this time, the construction of the refracting optical system is more complicated, and it also becomes difficult to attain aberration correction.

The balance of aberration of the lens groups in the catadioptric reduction projection optical system according to the present invention will now be discussed. The first lens group $G_1$ is arranged in the vicinity of the object surface, has a function of maintaining telecentric characteristics, and corrects distortion. The second and third lens groups $G_2$ and $G_3$ contribute to formation of the reduced image and to correction of the Petzval sum. In particular, the second lens group $G_2$ functions as a so-called field lens, and allows a light beam from a position near the optical axis of the first concave reflection mirror $M_1$ to pass therethrough. Thus, the light beam through second concave mirror $M_2$ at a position near the optical axis and generation of aberration in the second concave reflection mirror $M_2$ can be prevented. The negative distortion generated in the second and third lens groups $G_2$ and $G_3$ is corrected by the positive distortion of the first lens group $G_1$. Lens groups (fourth and fifth lens groups $G_4$ and $G_5$) provisionally disposed in the vicinity of the concave reflection mirrors are effective to correct higher order spherical aberration generated by the concave reflection mirrors. When the concave reflection mirror is constituted to be a non-spherical mirror, since aberration generated by the concave reflection mirror is minimized, the fourth and fifth lens groups $G_4$ and $G_5$ may be omitted.

Other objects, features, and effects of the present invention will become apparent from the following detailed description taken in conjunction with the accompanying drawings.

## BRIEF DESCRIPTION OF THE DRAWINGS

Fig. 1 shows an optical path of a first embodiment according to the present invention;
Fig. 2 shows aberration of the first embodiment according to the present invention;
Fig. 3 shows an optical path of a second embodiment according to the present invention;
Fig. 4 shows aberration of the second embodiment according to the present invention;
Fig. 5 shows an optical path of a third embodiment according to the present invention;
Fig. 6 shows aberration of the third embodiment according to the present invention;
Fig. 7 shows an optical path of a fourth embodiment according to the present invention;
Fig. 8 shows aberration of the fourth embodiment according to the present invention;
Fig. 9 shows an optical path of a fifth embodiment according to the present invention;
Fig. 10 shows aberration of the fifth embodiment according to the present invention;
Fig. 11 shows an optical path of a sixth embodiment according to the present invention;
Fig. 12 shows aberration of the sixth embodiment according to the present invention;
Fig. 13 shows an optical path of a seventh embodiment according to the present invention;
Fig. 14 shows aberration of the seventh embodiment according to the present invention;
Fig. 15 shows an optical path of an eighth embodiment according to the present invention; and
Fig. 16 shows aberration of the eighth embodiment according to the present invention.

## DESCRIPTION OF THE PREFERRED EMBODIMENTS

The preferred embodiments of the present invention will be described in detail hereinafter with reference to the accompanying drawings.

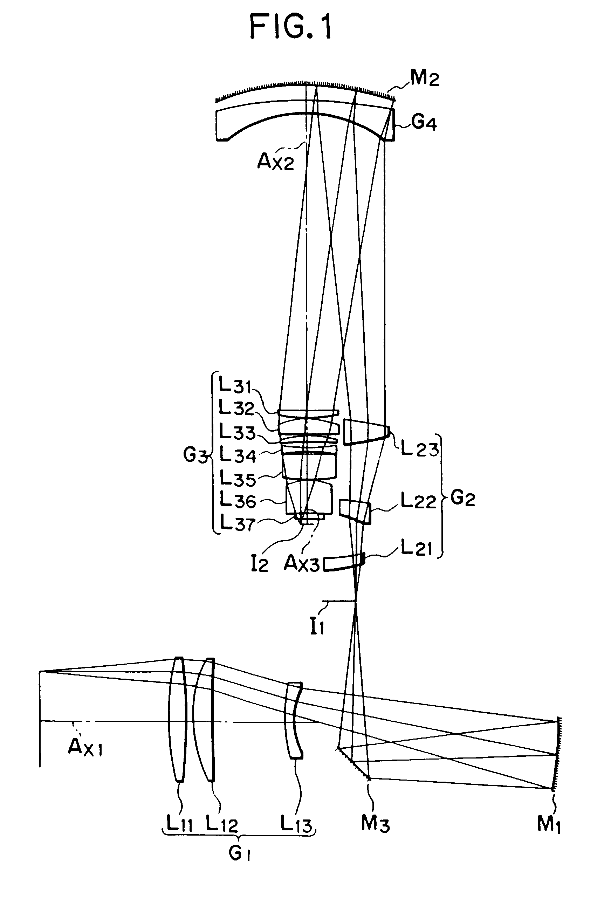

Fig. 1 is an optical path diagram showing a construction of the first embodiment according to the present invention. As shown in Fig. 1, a light beam from an object surface passes through a first lens group $G_1$ which comprises a biconvex positive lens $L_{11}$, a positive meniscus lens $L_{12}$ having a convex surface facing the object side, and a negative meniscus lens $L_{13}$ having a convex surface facing the object side, and has positive refractive power as a whole, and is reflected by a first concave reflection mirror $M_1$ having a magnification slightly smaller than unity. Then, the optical path is bent by a planar reflection mirror $M_3$. The first lens group $G_1$ mainly functions to correct distortion and to maintain telecentric characteristics. The first lens group $G_1$ and the first concave reflection mirror $M_1$ form a primary reduced image $I_1$.

A light beam from the primary image $I_1$ passes through a second lens group $G_2$ comprising a positive meniscus lens $L_{21}$ having a convex surface facing the primary image side, a negative meniscus lens $L_{22}$ having a concave surface facing the primary image side, and a biconvex positive lens $L_{23}$, and reaches a second concave reflection mirror $M_2$ having an enlargement factor via a fourth lens group $G_4$ having negative refractive power. The second lens group $G_2$ mainly functions to correct distortion and curvature of field, and functions as a field lens. The fourth lens group $G_4$ comprises a negative meniscus lens having a convex surface facing the second concave reflection mirror $M_2$ side, and functions to correct aberrations caused by the first and second concave reflection mirrors $M_1$ and $M_2$.

The light beam reflected by the second concave reflection mirror $M_2$ passes through the fourth lens group $G_4$ again, and then becomes incident on a third lens group $G_3$ having positive refractive power. The third lens group $G_3$ comprises, in succession from the incident side of a light beam, a negative meniscus lens $L_{31}$ having a concave lens facing the incident side, a positive meniscus lens $L_{32}$ having a convex surface facing the incident side, a positive

meniscus lens $L_{33}$ having a convex surface facing the incident side, a biconcave negative lens $L_{34}$, a biconvex positive lens $L_{35}$, a positive meniscus lens $L_{36}$ having a convex surface facing the incident side, and a positive meniscus lens $L_{37}$ having a convex surface facing the incident side. The third lens group $G_3$ has a positive Petzval sum to cancel the function of making the Petzval sum by the first and second concave reflection mirrors $M_1$ and $M_2$ negative. The third lens group $G_3$ forms a second image $I_2$ in a larger reduction scale than that of the primary image $I_1$.

In the above-mentioned construction, the first lens group $G_1$ and the first concave reflection mirror $M_1$ constitute a first partial optical system, and the second concave reflection mirror $M_2$ and the third lens group $G_3$ constitute a second partial optical system. The second lens group $G_2$ is disposed in the optical path between the first and second concave reflection mirrors $M_1$ and $M_2$. The planar reflection mirror $M_3$ for bending the optical path is obliquely disposed near the first lens group $G_1$ at an angle of 45° with respect to an optical axis $Ax_1$ of the first partial optical system, so that an optical axis $Ax_2$ of the second partial optical system extends perpendicular to the optical axis $Ax_1$ of the first partial optical system. The second lens group $G_2$ is disposed only one side of the second partial optical system so as to focus light reflected by the first concave reflection mirror $M_1$ without shielding a light beam propagating toward the second concave reflection mirror $M_2$.

The first embodiment has a reduction factor of +0.20 or 1/5 as a whole, and achieves a numerical aperture of (N. A.) of 0.45 in a ring-shaped view field centered at an arc having a radius of 20 mm from the optical axis.

Table 1 below shows data of the first embodiment.

In Table 1, the signs of the refractive index and the plane-to-plane distance are reversed by reflection by the concave reflection mirror. The refractive index of each glass material corresponds to that at the wavelength (248 nm) of KrF. Note that the position of the planar reflection mirror $M_3$ for bending the optical path is omitted since it is not essential in the optical design.

Table 1

| No. | Radius of Curvature | Plane-to-Plane Distance | Refractive Index | | |
|---|---|---|---|---|---|
| | (Object Surface) | 256.414 | 1.0000 | | |
| 1 | 571.882 | 35.000 | 1.50890 | (quartz) | $L_{11}$ |
| 2 | -1107.127 | 13.569 | 1.0000 | | |
| 3 | 286.383 | 38.000 | 1.50890 | (quartz) | $L_{12}$ |
| 4 | 2061.034 | 143.443 | 1.0000 | | |
| 5 | 323.826 | 20.000 | 1.50890 | (quartz) | $L_{13}$ |
| 6 | 134.427 | 535.000 | 1.0000 | | |
| 7 | -816.864 | -800.000 | -1.0000 | | $M_1$ |
| 8 | -435.732 | -25.000 | -1.50890 | (quartz) | $L_{21}$ |
| 9 | -664.126 | -96.462 | -1.0000 | | |
| 10 | 231.231 | -25.000 | -1.50890 | (quartz) | $L_{22}$ |
| 11 | 750.143 | -107.120 | -1.0000 | | |
| 12 | -622.742 | -59.000 | -1.50890 | (quartz) | $L_{23}$ |
| 13 | 723.951 | -616.105 | -1.0000 | | |
| 14 | 259.861 | -25.000 | -1.50890 | (quartz) | $G_4$ |
| 15 | 891.669 | -28.536 | -1.0000 | | |
| 16 | 537.817 | 28.536 | 1.0000 | | $M_2$ |
| 17 | 891.669 | 25.000 | 1.50890 | (quartz) | $G_4$ |
| 18 | 259.861 | 602.523 | 1.0000 | | |
| 19 | -1642.894 | 12.745 | 1.50890 | (quartz) | $L_{31}$ |
| 20 | -356.710 | 2.000 | 1.0000 | | |
| 21 | 166.981 | 32.465 | 1.50890 | (quartz) | $L_{32}$ |
| 22 | -4368.603 | 0.201 | 1.0000 | | |
| 23 | 188.353 | 14.825 | 1.50890 | (quartz) | $L_{33}$ |
| 24 | 489.910 | 10.157 | 1.0000 | | |
| 25 | -401.443 | 10.220 | 1.50890 | (quartz) | $L_{34}$ |
| 26 | 370.153 | 3.669 | 1.0000 | | |

Table 1   (continued)

| No. | Radius of Curvature | Plane-to-Plane Distance | Refractive Index | | |
|---|---|---|---|---|---|
| | Data of First Embodiment | | | | |
| 27 | 1112.370 | 53.780 | 1.50890 | (quartz) | $L_{35}$ |
| 28 | -387.055 | 0.100 | 1.0000 | | |
| 29 | 106.932 | 70.805 | 1.50890 | (quartz) | $L_{36}$ |
| 30 | 329.200 | 0.100 | 1.0000 | | |
| 31 | 153.221 | 12.340 | 1.50890 | (quartz) | $L_{37}$ |
| 32 | 983.363 | 10.000 | 1.0000 | | |
| 33 | (Image Surface) | | | | |

<Condition Corresponding Values>

$\beta_{G3}$ =   0.0761
$\beta_{M1}$ =   -0.8606
$\beta_{M2}$ =   -1.225

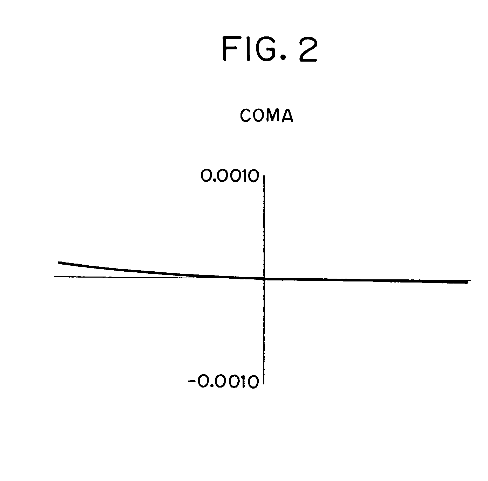

Fig. 2 shows coma for explaining the imaging performance of the first embodiment. Fig. 2 shows coma in the meridional direction at the center of the ring-shaped view field. As can be seen from Fig. 2, this embodiment maintains an excellent imaging performance.

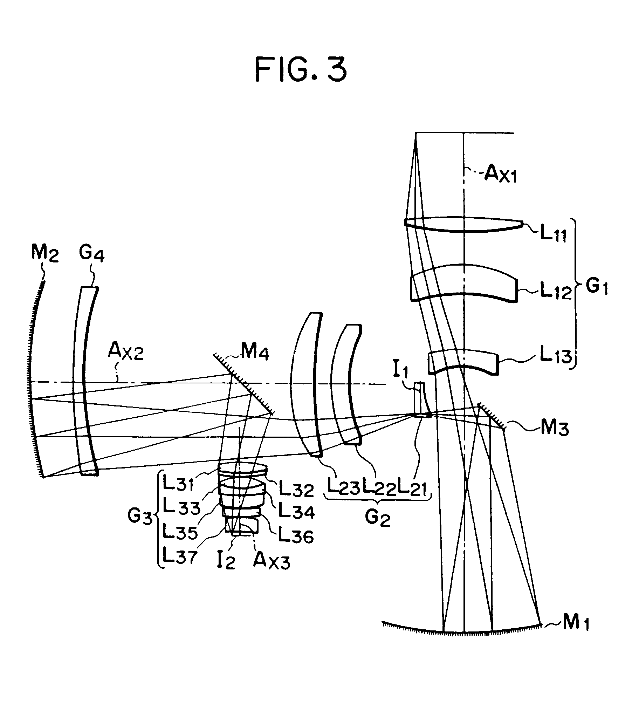

As shown in Fig. 3, in a second embodiment according to the present invention, a light beam from the object surface passes through a first lens group $G_1$ which comprises a biconvex positive lens $L_{11}$, a positive meniscus lens $L_{12}$ having a convex surface facing the incident side of the light beam, and a negative meniscus lens $L_{13}$ having a convex surface facing the incident side, and has positive refractive power as a whole, and is then reflected by a first concave reflection mirror $M_1$ having a magnification slightly smaller than unity. The reflected light beam is deflected by a planar reflection mirror $M_3$ which is obliquely disposed at 45° with respect to an optical axis $Ax_1$ of the first lens group $G_1$, and then becomes incident on a second lens group $G_2$ of negative refractive power. The second lens group $G_2$ comprises, in succession from the incident side of a light beam, a negative lens $L_{21}$ having a substantially plano-concave shape, a negative meniscus lens $L_{22}$ having a concave surface facing the incident side, and a positive meniscus lens $L_{23}$ having a concave surface facing the incident side, and forms a primary image $I_1$ as a reduced image of an object in the negative lens $L_{21}$.

The light beam emerging from the second lens group $G_2$ is reflected by a second concave reflection mirror $M_2$ having a magnification larger than unity via a fourth lens group $G_4$ of negative refractive power. The fourth lens group $G_4$ comprises a negative meniscus lens having a convex surface facing the second concave reflection mirror $M_2$. The light beam reflected by the second concave reflection mirror $M_2$ is deflected by a planar reflection mirror $M_4$, which is obliquely arranged at 45° with respect to an optical axis $Ax_2$ of the second lens group $G_2$, via the fourth lens group $G_4$ again, and becomes incident on a third lens group $G_3$ of positive refractive power. The third lens group $G_3$ comprises, in succession from the incident side of a light beam, a biconvex positive lens $L_{31}$, a negative meniscus lens $L_{32}$ having a concave surface facing the incident side, a biconvex positive lens $L_{33}$, a negative meniscus lens $L_{34}$ having a concave surface facing the incident side, a positive meniscus lens $L_{35}$ having a concave surface facing the incident side, a negative meniscus lens $L_{36}$ having a concave surface facing the incident side, and a positive meniscus lens $L_{37}$ having a convex surface facing the incident side, and forms a secondary image $I_2$ in a larger reduction scale than that of the primary image $I_1$. The negative lens $L_{21}$ in the second lens group $G_2$ is arranged at only one side so as not to shield a light beam passing through the first lens group $G_1$.

The second embodiment, as well, has a reduction factor of +0.20 or 1/5 as a whole, and achieves a numerical aperture of (N.A.) of 0.45 in a ring-shaped view field centered at an arc having a radius of 20 mm from the optical axis.

Table 2 below shows data of the second embodiment.

In Table 2, the refractive index of each glass material corresponds to that at the wavelength (193 nm) of ArF.

Table 2

| No. | Radius of Curvature | Plane-to-Plane Distance | Refractive Index | | |
|---|---|---|---|---|---|
| | Data of Second Embodiment | | | | |
| | (Object Surface) | 169.405 | 1.0000 | | |

Table 2  (continued)

| | No. | Radius of Curvature | Plane-to-Plane Distance | Refractive Index | | |
|---|---|---|---|---|---|---|
| | 1 | 901.701 | 30.575 | 1.560194 | (quartz) | $L_{11}$ |
| | 2 | -510.578 | 65.853 | 1.0000 | | |
| | 3 | 220.954 | 60.000 | 1.560194 | (quartz) | $L_{12}$ |
| | 4 | 318.898 | 110.000 | 1.0000 | | |
| | 5 | 295.985 | 33.350 | 1.560194 | (quartz) | $L_{13}$ |
| | 6 | 109.856 | 544.112 | 1.0000 | | |
| | 7 | -644.876 | -578.247 | -1.0000 | | $M_1$ |
| | 8 | 125.313 | -20.000 | -1.560194 | (quartz) | $L_{21}$ |
| | 9 | -19308.942 | -133.068 | -1.0000 | | |
| | 10 | 285.898 | -40.367 | -1.560194 | (quartz) | $L_{22}$ |
| | 11 | 239.639 | -32.560 | -1.0000 | | |
| | 12 | 838.750 | -48.824 | -1.560194 | (quartz) | $L_{23}$ |
| | 13 | 270.000 | -413.387 | -1.0000 | | |
| | 14 | 690.339 | -20.000 | -1.560194 | (quartz) | $G_4$ |
| | 15 | 1371.252 | -85.603 | -1.0000 | | |
| | 16 | 769.864 | 85.603 | 1.0000 | | $M_2$ |
| | 17 | 1371.252 | 20.000 | 1.560194 | (quartz) | $G_4$ |
| | 18 | 690.339 | 478.013 | 1.0000 | | |
| | 19 | 193.080 | 19.107 | 1.501375 | (fluorite) | $L_{31}$ |
| | 20 | -330.493 | 3.128 | 1.0000 | | |
| | 21 | -237.620 | 4.8000 | 1.560194 | (quartz) | $L_{32}$ |
| | 22 | -404.696 | 0.100 | 1.0000 | | |
| | 23 | 84.943 | 25.587 | 1.501375 | (fluorite) | $L_{33}$ |
| | 24 | -168.592 | 0.362 | 1.0000 | | |
| | 25 | -164.717 | 13.099 | 1.560194 | (quartz) | $L_{34}$ |
| | 26 | -296.532 | 2.263 | 1.0000 | | |
| | 27 | -201.221 | 24.203 | 1.501375 | (fluorite) | $L_{35}$ |
| | 28 | -184.897 | 0.552 | 1.0000 | | |
| | 29 | -353.513 | 16.515 | 1.560194 | (quartz) | $L_{36}$ |
| | 30 | -514.935 | 0.691 | 1.0000 | | |
| | 31 | 170.098 | 29.846 | 1.560194 | (quartz) | $L_{37}$ |
| | 32 | 642.145 | 6.065 | 1.0000 | | |
| | 33 | (Image Surface) | | | | |

<Condition Corresponding Values>

$\beta_{G3} =$  0.2013
$\beta_{M1} =$  -0.762
$\beta_{M2} =$  -0.974

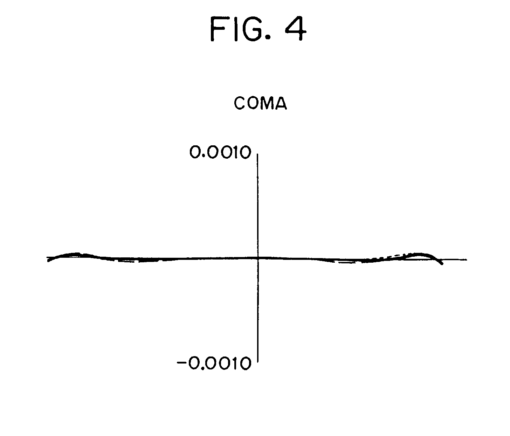

Fig. 4 shows coma for explaining the imaging performance of the second embodiment. Fig. 4 shows coma in the meridional direction at the center of the ring-shaped view field. Note that a broken curve in Fig. 4 represents coma at 193.3 nm, a broken curve longer the curve representing coma at 193.3 nm represents coma at 192.9 nm, and a dotted curve represents coma at 193.7 nm. As can be seen from Fig. 4, the second embodiment can achieve correction of chromatic aberration within a range of ±0.4 nm at the wavelength of ArF, and maintains an excellent imaging performance.

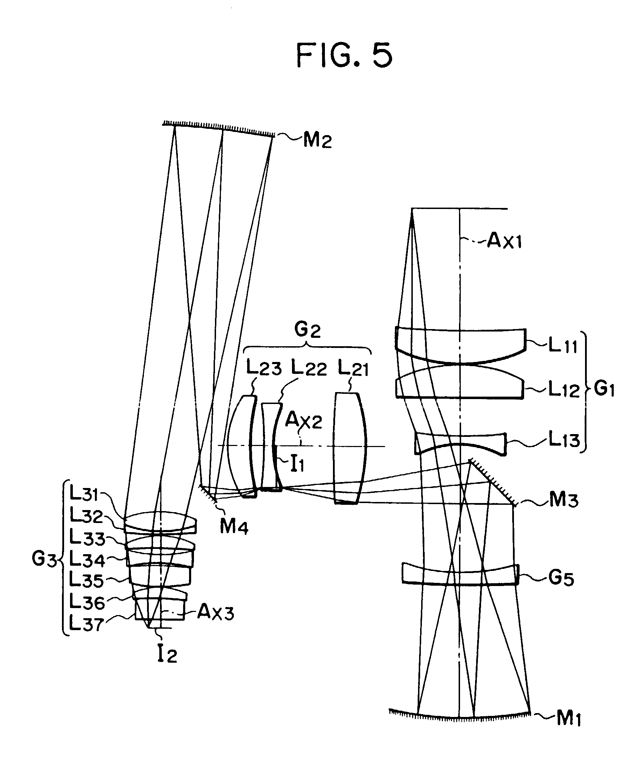

A third embodiment of the present invention will be described below with reference to Fig. 5. Referring to Fig. 5, a light beam from the object surface passes through a first lens group $G_1$ which comprises a positive meniscus lens $L_{11}$ having a concave surface facing the incident side of a light beam, a biconvex positive lens $L_{12}$, and a biconcave negative lens $L_{13}$, and has positive refractive power as a whole, and becomes incident on a first concave reflection

mirror $M_1$, which has a magnification slightly smaller than unity, via a fifth lens group $G_5$. The fifth lens group $G_5$ comprises a negative meniscus lens having a convex surface facing the first concave reflection mirror $M_1$, and functions to correct aberration generated by the first concave reflection mirror $M_1$ and second concave reflection mirror $M_2$. The light beam reflected by the first concave reflection mirror $M_1$ is deflected by a planar reflection mirror $M_3$ via the fifth lens group $G_5$ again, and becomes incident on a second lens group $G_2$ of positive refractive power.

The planar reflection mirror $M_3$ is obliquely arranged at 45° with respect to an optical axis $Ax_1$ of the first lens group $G_1$ in the optical path between the fifth and first lens group $G_5$ and $G_1$. The second lens group $G_2$ comprises a biconvex positive lens $L_{21}$, a biconcave negative lens $L_{22}$, and a positive meniscus lens $L_{23}$ having a concave surface facing the incident side of a light beam. The light beam incident on the second lens group $G_2$ forms a primary image $I_1$ as a reduced image of an object in the negative lens $L_{22}$. The light beam emerging from the second lens group $G_2$ is deflected by a fourth planar reflection mirror $M_4$ which is obliquely arranged at 45° with respect to an optical axis $Ax_2$ of the second lens group $G_2$, is reflected by the second concave reflection mirror $M_2$ having a magnification larger than unity, and then becomes incident on a third lens group $G_3$ of positive refractive power. The third lens group $G_3$ comprises a biconvex positive lens $L_{31}$, a negative meniscus lens $L_{32}$ having a convex surface facing the incident side, a positive meniscus lens $L_{33}$ having a convex surface facing the incident side, a biconcave negative lens $L_{34}$, a biconvex positive lens $L_{35}$, a positive meniscus lens $L_{36}$ having a convex surface facing the incident side, and a positive meniscus lens $L_{37}$ having a convex surface facing the incident side. The third lens group $G_3$ forms a secondary image $I_2$ in a larger reduction scale than that of the primary image $I_1$ at the exit side thereof.

The third embodiment has a reduction factor of +0.25 or 1/4 as a whole, and achieves a numerical aperture of (N. A.) of 0.45 in a ring-shaped view field centered at an arc having a radius of 20 mm from the optical axis.

Table 3 below shows data of the third embodiment.

In Table 3, the refractive index of each glass material corresponds to that at the wavelength (248 nm) of KrF.

Table 3

| No. | Radius of Curvature | Plane-to-Plane Distance | Refractive Index | | |
|---|---|---|---|---|---|
| | (Object Surface) | 196.209 | 1.0000 | | |
| 1 | -1726.924 | 54.622 | 1.508385 | (quartz) | $L_{11}$ |
| 2 | 260.643 | 0.100 | 1.0000 | | |
| 3 | 214.288 | 55.000 | 1.508385 | (quartz) | $L_{12}$ |
| 4 | -3184.516 | 61.226 | 1.0000 | | |
| 5 | -634.272 | 15.000 | 1.508385 | (quartz) | $L_{13}$ |
| 6 | 142.779 | 209.364 | 1.0000 | | |
| 7 | -324.815 | 20.000 | 1.508385 | (quartz) | $G_5$ |
| 8 | -1599.830 | 223.380 | 1.0000 | | |
| 9 | -537.154 | -223.380 | -1.0000 | | $M_1$ |
| 10 | -1599.830 | -20.000 | -1.508385 | (quartz) | $G_5$ |
| 11 | -324.815 | -355.860 | -1.0000 | | |
| 12 | -286.947 | -55.000 | -1.508385 | (quartz) | $L_{21}$ |
| 13 | 1629.963 | -101.890 | -1.0000 | | |
| 14 | 165.609 | -15.000 | -1.508385 | (quartz) | $L_{22}$ |
| 15 | -750.059 | -20.606 | -1.0000 | | |
| 16 | 343.901 | -39.768 | -1.508385 | (quartz) | $L_{23}$ |
| 17 | 154.033 | -630.899 | -1.0000 | | |
| 18 | 962.895 | 630.899 | 1.0000 | | $M_2$ |
| 19 | 149.915 | 32.150 | 1.467877 | (fluorite) | $L_{31}$ |
| 20 | -187.485 | 0.100 | 1.0000 | | |
| 21 | -186.839 | 7.000 | 1.508385 | (quartz) | $L_{32}$ |
| 22 | -727.375 | 0.100 | 1.0000 | | |
| 23 | 117.358 | 20.864 | 1.508385 | (quartz) | $L_{33}$ |
| 24 | 647.785 | 8.591 | 1.0000 | | |
| 25 | -284.413 | 15.450 | 1.508385 | (quartz) | $L_{34}$ |
| 26 | 193.285 | 4.300 | 1.0000 | | |

Table 3   (continued)

| | Data of Third Embodiment | | | | |
|---|---|---|---|---|---|
| No. | Radius of Curvature | Plane-to-Plane Distance | Refractive Index | | |
| 27 | 388.801 | 36.187 | 1.467877 | (fluorite) | $L_{35}$ |
| 28 | -216.450 | 0.100 | 1.0000 | | |
| 29 | 113.246 | 19.238 | 1.467877 | (fluorite) | $L_{36}$ |
| 30 | 459.066 | 0.100 | 1.0000 | | |
| 31 | 221.661 | 33.854 | 1.508385 | (quartz) | $L_{37}$ |
| 32 | 1502.269 | 15.400 | 1.0000 | | |
| 33 | (Image Surface) | | | | |

<Condition Corresponding Values>

$\beta_{G3} =$ 0.1342
$\beta_{M1} =$ -1.058
$\beta_{M2} =$ -2.008

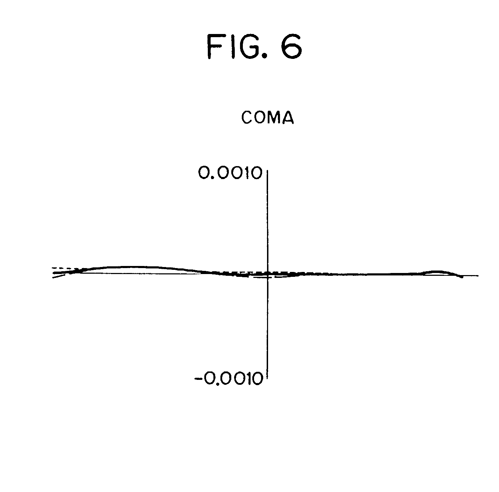

Fig. 6 shows coma for explaining the imaging performance of the third embodiment. Fig. 6 shows coma in the meridional direction at the center of the ring-shaped view field. Note that a solid curve in Fig. 6 represents coma at 248.4 nm, an alternate long and short dashed curve represents coma at 252.4 nm, and an alternate long and two short dashed curve represents coma at 244.4 nm. As can be seen from Fig. 6, the third embodiment can achieve correction of chromatic aberration within a range of ±4 nm at the wavelength of KrF, and maintains an excellent imaging performance.

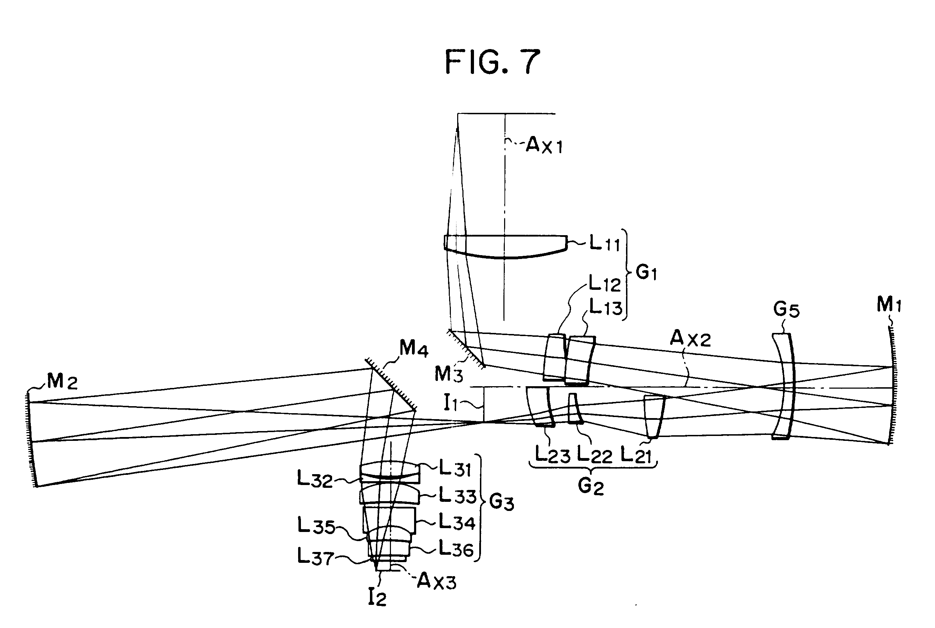

A fourth embodiment of the present invention will be described below with reference to Fig. 7. In the fourth embodiment, as shown in Fig. 7, a light beam from the object surface is incident on a first lens group $G_1$ of positive refractive power. In the first lens group $G_1$, the light beam passes through a positive meniscus lens $L_{11}$ having a concave surface facing the incident side of a light beam, and is then deflected by a planar reflection mirror $M_3$ which is obliquely arranged at 45° with respect to an optical axis $Ax_1$ of the first lens group $G_1$. The deflected light beam passes through a biconvex positive lens $L_{12}$ and a negative meniscus lens $L_{13}$ having a convex surface facing the incident side of a light beam, and then reaches a first concave reflection mirror $M_1$ having a magnification slightly smaller than unity via a fifth lens group $G_5$ of negative refractive power. The fifth lens group $G_5$ comprises a negative meniscus lens having a convex surface facing the first concave reflection mirror side. The light beam reflected by the first concave reflection mirror $M_1$ forms a primary image $I_1$ as a reduced image of an object via the fifth lens group $G_5$ again and a second lens group $G_2$ of positive refractive power.

The second lens group $G_2$ comprises, in succession from the incident side of a light beam, a biconvex positive lens $L_{21}$, a negative meniscus lens $L_{22}$ having a concave surface facing the incident side, and a positive meniscus lens $L_{23}$ having a concave surface facing the incident side. The light beam from the primary image $I_1$ is reflected by a second concave reflection mirror $M_2$ having a magnification larger than unity. The optical path of the reflected light beam is deflected by a planar reflection mirror $M_4$, and the light beam then reaches a third lens group $G_3$ of positive refractive power. The planar reflection mirror $M_4$ is obliquely arranged at 45° with respect to an optical axis $Ax_3$ of the third lens group $G_3$. The third lens group $G_3$ comprises, in succession from the incident side of a light beam, a biconvex positive lens $L_{31}$, a negative meniscus lens $L_{32}$ having a concave surface facing the incident side, a positive meniscus lens $L_{33}$ having a convex lens facing the incident side, a biconcave negative lens $L_{34}$, a positive meniscus lens $L_{35}$ having a convex surface facing the incident side, a positive meniscus lens $L_{36}$ having a convex surface facing the incident side, and a positive meniscus lens $L_{37}$ having a convex surface facing the incident side, and forms a secondary image $I_2$ in a larger reduction scale than that of the primary image $I_1$ at its exit side. The positive lens $L_{12}$ and the negative lens $L_{13}$ of the first lens group $G_1$ are arranged at only one side so as to allow a light beam toward the first concave reflection mirror to pass therethrough without shielding a light beam in the second lens group $G_2$. The second lens group $G_2$ is arranged at only one side so as to guide a light beam from the first concave reflection mirror $M_1$ without shielding a light beam in the first lens group $G_1$.

The fourth embodiment has a reduction factor of +0.25 or 1/4 as a whole, and achieves a numerical aperture of (N.A.) of 0.30 in a ring-shaped view field centered at an arc having a radius of 20 mm from the optical axis.

Table 4 below shows data of the fourth embodiment.

In Table 4, the refractive index of each glass material corresponds to that at the wavelength (248 nm) of KrF.

Table 4

| No. | Radius of Curvature | Plane-to-Plane Distance | Refractive Index | | |
|---|---|---|---|---|---|
| | Data of Fourth Embodiment | | | | |
| | (Object Surface) | 196.018 | 1.0000 | | |
| 1 | -5157.341 | 35.000 | 1.508385 | (quartz) | $L_{11}$ |
| 2 | -342.424 | 264.350 | 1.0000 | | |
| 3 | 418.888 | 35.000 | 1.508385 | (quartz) | $L_{12}$ |
| 4 | -2971.961 | 0.100 | 1.0000 | | |
| 5 | 479.951 | 35.000 | 1.508385 | (quartz) | $L_{13}$ |
| 6 | 219.080 | 314.800 | 1.0000 | | |
| 7 | -194.621 | 18.000 | 1.508385 | (quartz) | $G_5$ |
| 8 | -370.491 | 159.400 | 1.0000 | | |
| 9 | -586.251 | -159.400 | -1.0000 | | $M_1$ |
| 10 | -370.491 | -18.000 | -1.508385 | (quartz) | $G_5$ |
| 11 | -194.621 | -187.600 | -1.0000 | | |
| 12 | -275.679 | 35.500 | -1.508385 | (quartz) | $L_{21}$ |
| 13 | 507.601 | -112.350 | -1.0000 | | |
| 14 | 144.909 | -6.500 | -1.508385 | (quartz) | $L_{22}$ |
| 15 | -700.764 | -35.700 | -1.0000 | | |
| 16 | 198.506 | -35.000 | -1.508385 | (quartz) | $L_{23}$ |
| 17 | 137.057 | -793.600 | -1.0000 | | |
| 18 | 934.699 | 697.100 | 1.0000 | | $M_2$ |
| 19 | 167.048 | 23.800 | 1.467877 | (fluorite) | $L_{31}$ |
| 20 | -305.250 | 3.250 | 1.0000 | | |
| 21 | -269.515 | 6.500 | 1.508385 | (quartz) | $L_{32}$ |
| 22 | 1602.279 | 0.100 | 1.0000 | | |
| 23 | 83.085 | 35.000 | 1.467877 | (fluorite) | $L_{33}$ |
| 24 | 534.963 | 8.000 | 1.0000 | | |
| 25 | -2442.622 | 28.500 | 1.508385 | (quartz) | $L_{34}$ |
| 26 | 51.803 | 1.350 | 1.0000 | | |
| 27 | 52.498 | 23.600 | 1.467877 | (fluorite) | $L_{35}$ |
| 28 | 895.515 | 0.100 | 1.0000 | | |
| 29 | 159.859 | 23.400 | 1.467877 | (fluorite) | $L_{36}$ |
| 30 | 1657.174 | 0.100 | 1.0000 | | |
| 31 | 216.018 | 7.500 | 1.508385 | (quartz) | $L_{37}$ |
| 32 | 434.319 | 15.000 | 1.0000 | | |
| 33 | (Image Surface) | | | | |

<Condition Corresponding Values>

$\beta_{G3} =$   0.2035
$\beta_{M1} =$   -0.8795
$\beta_{M2} =$   -1.684

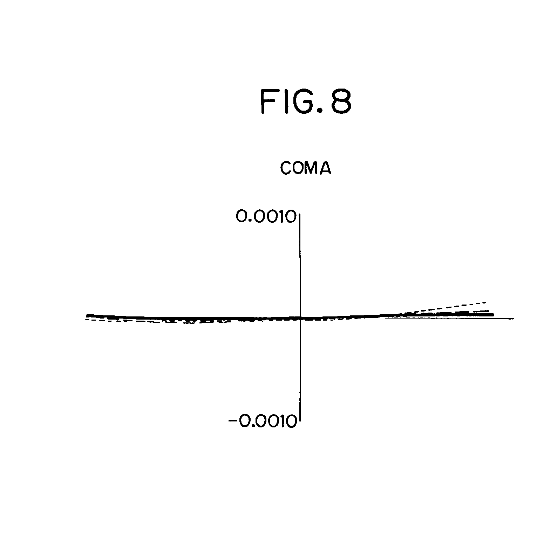

Fig. 8 shows coma for explaining the imaging performance of the fourth embodiment. Fig. 8 shows coma in the meridional direction at the center of the ring-shaped view field. Note that a solid curve in Fig. 8 represents coma at 248.4 nm, a broken curve represents coma at 238.4 nm, and a dotted curve represents coma at 258.4 nm. As can be seen from Fig. 8, the fourth embodiment can achieve correction of chromatic aberration within a range of ±10 nm at the wavelength of KrF, and maintains an excellent imaging performance.

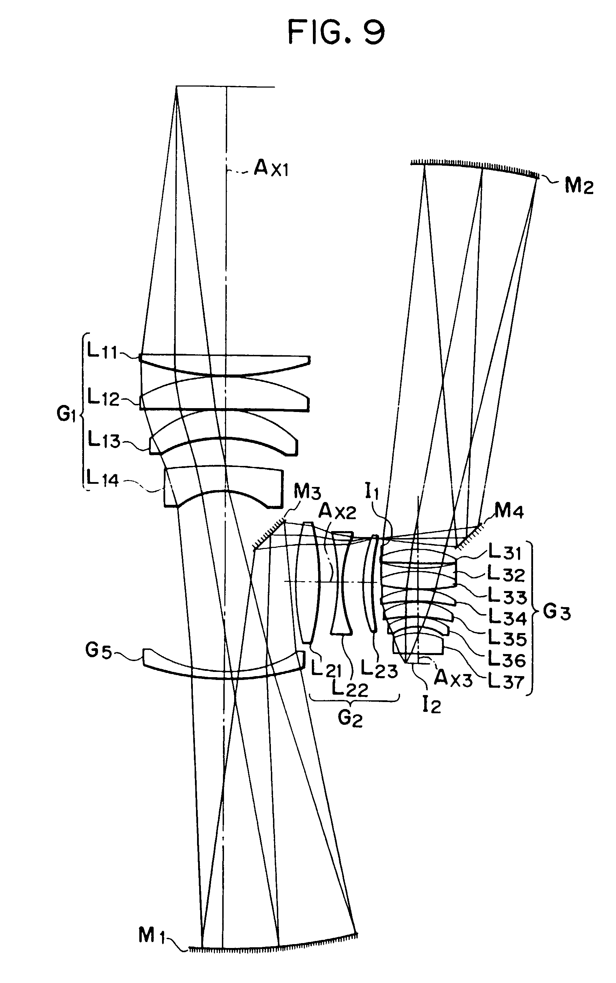

A fifth embodiment of the present invention will be described below with reference to Fig. 9. In the fifth embodiment shown in Fig. 9, a second concave reflection mirror $M_2$ comprises a reflection mirror having a non-spherical surface. Referring to Fig. 9, a light beam from the object surface reaches a first concave reflection mirror $M_1$ having a magni-

fication slightly smaller than unity via a first lens group $G_1$ which comprises a positive meniscus lens $L_{11}$ having a concave surface facing the incident side of a light beam, a positive meniscus lens $L_{12}$ having a convex surface facing the incident side, a positive meniscus lens $L_{13}$ having a convex surface facing the incident side, and a positive meniscus lens $L_{14}$ having a convex surface facing the incident side, and has positive refractive power as a whole, and a fifth lens group $G_5$ of negative refractive power. The fifth lens group $G_5$ comprises a negative meniscus lens having a convex surface facing the first concave reflection mirror side. The light beam reflected by the first concave reflection mirror $M_1$ is deflected by a planar reflection mirror $M_3$, which is obliquely arranged at 45° with respect to an optical axis $Ax_1$ of the first lens group $G_1$, via the fifth lens group $G_5$ again, and then becomes incident on a second lens group $G_2$ of negative refractive power. The second lens group $G_2$ comprises a biconvex positive lens $L_{21}$, a biconcave negative lens $L_{22}$, and a positive meniscus lens $L_{23}$ having a convex surface facing the incident side of a light beam, and forms a primary reduced image $I_1$ at its exit side.

The light beam from the primary image $I_1$ is deflected by a planar reflection mirror $M_4$ which is obliquely arranged at 45° with respect to an optical axis $Ax_2$ of the second lens group $G_2$, and reaches a second concave reflection mirror $M_2$ having a magnification larger than unity and a non-spherical shape. The light beam reflected by the second concave reflection mirror $M_2$ becomes incident on a third lens group $G_3$ of positive refractive power. The third lens group $G_3$ comprises a biconvex positive lens $L_{31}$, a biconcave negative lens $L_{32}$, a biconvex positive lens $L_{33}$, a positive meniscus lens $L_{34}$ having a convex surface facing the incident side of a light beam, a positive meniscus lens $L_{35}$ having a convex surface facing the incident side, a negative meniscus lens $L_{36}$ having a convex surface facing the incident side, and a positive meniscus lens $L_{37}$ having a convex surface facing the incident side, and forms a secondary image $I_2$ in a larger reduction scale than that of the primary image $I_1$.

The fifth embodiment has a reduction factor of +0.25 or 1/4 as a whole, and achieves a numerical aperture of (N. A.) of 0.5 in a ring-shaped view field centered at an arc having a radius of 24.25 mm from the optical axis.

Table 5 below shows data of the fifth embodiment.

In Table 5, as for the non-spherical reflection surface, only the radius of paraxial curvature is presented, and when a tangential plane at the vertex of a non-spherical surface is considered, a position, where the optical axis passes, on the tangential plane is defined as an origin, and a displacement, in the optical axis direction, of the non-spherical surface at a position of a height y on the tangential plane is represented by x with reference to the vertex of the non-spherical surface while the propagating direction of light is assumed to be the positive direction, the non-spherical surface shape is given by the following equation:

$$x = cy^2/\{1 + (1 - \kappa c^2 y^2)^{1/2}\}$$
$$+ C_4 y^4 + C_6 y^6 + C_8 y^8 + C_{10} y^{10}$$

where c is the curvature (the reciprocal number of the radius r of curvature) of the non-spherical surface at the vertex of the non-spherical surface, $\kappa$ is a quadrics parameter, and $C_4$, $C_6$, $C_8$, and $C_{10}$ are non-spherical surface coefficients.

In Table 5, the refractive index of each glass material corresponds to that at the wavelength (248 nm) of KrF.

Table 5

| | Fifth Embodiment | | | | |
|---|---|---|---|---|---|
| No. | Radius of Curvature | Plane-to-Plane Distance | Refractive Index | | |
| | (Object Surface) | 537.071 | 1.0000 | | |
| 1 | -13337.695 | 38.029 | 1.508385 | (quartz) | $L_{11}$ |
| 2 | -559.442 | 0.100 | 1.0000 | | |
| 3 | 329.313 | 71.406 | 1.508385 | (quartz) | $L_{12}$ |
| 4 | 4423.247 | 0.100 | 1.0000 | | |
| 5 | 208.809 | 57.000 | 1.508385 | (quartz) | $L_{13}$ |
| 6 | 247.488 | 54.831 | 1.0000 | | |
| 7 | 889.869 | 50.000 | 1.508385 | (quartz) | $L_{14}$ |
| 8 | 140.636 | 362.130 | 1.0000 | | |
| 9 | -277.199 | 15.000 | 1.508385 | (quartz) | $G_5$ |
| 10 | -485.421 | 540.415 | 1.0000 | | |
| 11 | -1017.359 | -540.415 | -1.0000 | | $M_1$ |

Table 5  (continued)

| No. | Radius of Curvature | Plane-to-Plane Distance | Refractive Index | | |
|---|---|---|---|---|---|
| 12 | -485.421 | -15.000 | -1.508385 | (quartz) | $G_5$ |
| 13 | -277.199 | -326.174 | -1.0000 | | |
| 14 | -494.427 | -48.250 | -1.508385 | (quartz) | $L_{21}$ |
| 15 | 491.077 | -38.033 | -1.0000 | | |
| 16 | 361.893 | -10.000 | -1.508385 | (quartz) | $L_{22}$ |
| 17 | -260.009 | -40.978 | -1.0000 | | |
| 18 | -279.421 | -17.860 | -1.508385 | (quartz) | $L_{23}$ |
| 19 | -543.231 | -934.426 | -1.0000 | | |
| 20 | 1153.584 | 773.262 | 1.0000 | (non-spherical) | $M_2$ |
| 21 | 187.601 | 29.381 | 1.467877 | (fluorite) | $L_{31}$ |
| 22 | -1450.353 | 6.033 | 1.0000 | | |
| 23 | -391.392 | 9.000 | 1.508385 | (quartz) | $L_{32}$ |
| 24 | 179.475 | 3.183 | 1.0000 | | |
| 25 | 213.669 | 29.199 | 1.467877 | (fluorite) | $L_{33}$ |
| 26 | -621.952 | 0.100 | 1.0000 | | |
| 27 | 137.369 | 29.803 | 1.508385 | (quartz) | $L_{34}$ |
| 28 | 458.595 | 0.100 | 1.0000 | | |
| 29 | 135.180 | 28.421 | 1.467877 | (fluorite) | $L_{35}$ |
| 30 | 268.007 | 0.100 | 1.0000 | | |
| 31 | 121.989 | 16.840 | 1.508385 | (quartz) | $L_{36}$ |
| 32 | 87.217 | 11.990 | 1.0000 | | |
| 33 | 111.525 | 42.765 | 1.467877 | (fluorite) | $L_{37}$ |
| 34 | 841.067 | 19.747 | 1.0000 | | |
| 35 | (Image Surface) | | | | |

<Non-spherical Surface Coefficient>

21st surface (second concave reflection mirror $M_2$)

$\kappa$    1.0
$C_4$    $0.980896 \times 10^{-10}$
$C_6$    $0.374676 \times 10^{-15}$
$C_8$    $0.830862 \times 10^{-21}$
$C_{10}$    $0.705084 \times 10^{-26}$

<Condition Corresponding Values>

$\beta_{G3} =$    0.157
$\beta_{M1} =$    -0.811
$\beta_{M2} =$    -1.733

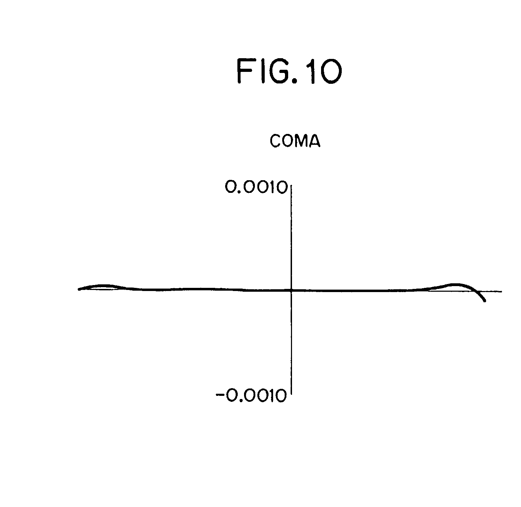

Fig. 10 shows coma of the fifth embodiment. Fig. 10 shows coma in the meridional direction at the center of the ring-shaped view field. As can be seen from Fig. 10, the fifth embodiment maintains an excellent imaging performance.

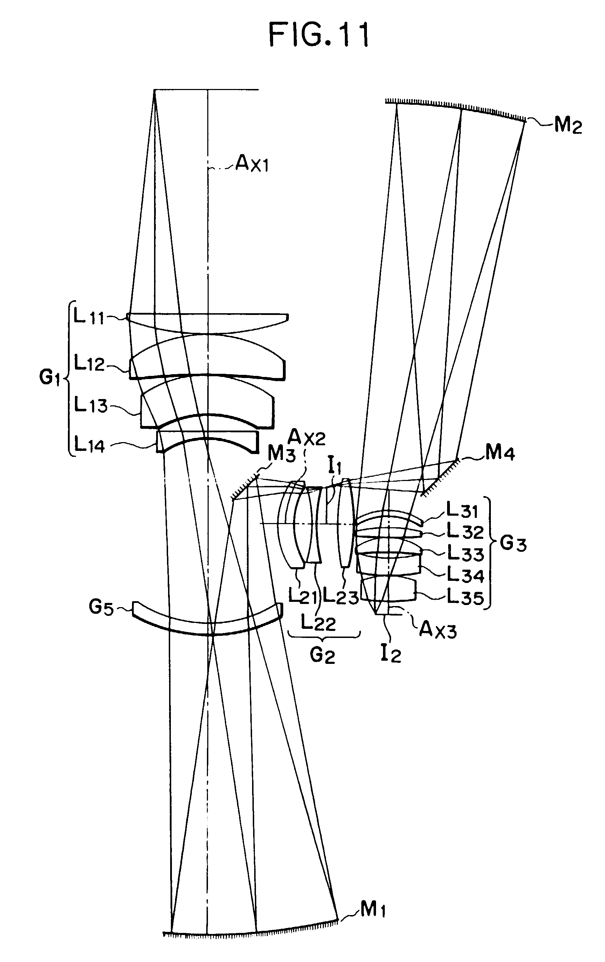

A sixth embodiment of the present invention will be described below with reference to Fig. 11. In the sixth embodiment, each of first and second concave reflection mirrors $M_1$ and $M_2$ has a non-spherical reflection surface. Referring to Fig. 11, a light beam from the object surface passes through a first lens group $G_1$ which comprises a biconvex positive lens $L_{11}$, a positive meniscus lens $L_{12}$ having a convex surface facing the incident side of a light beam, a negative meniscus lens $L_{13}$ having a convex surface facing the incident side, and a negative meniscus lens $L_{14}$ having a convex surface facing the incident side, and has positive refractive power as a whole, and then reaches a first concave reflection mirror $M_1$ having a magnification slightly smaller than unity via a fifth lens group $G_5$ of negative refractive power. The

fifth lens group $G_5$ comprises a negative meniscus lens having a convex surface facing the first concave reflection mirror $M_1$ side.

The light beam reflected by the first concave reflection mirror $M_1$ is deflected by a planar reflection mirror $M_3$, which is obliquely arranged at 45° with respect to an optical axis $Ax_1$ of the first lens group $G_1$, via the fifth lens group $G_5$ again, and becomes incident on a second lens group $G_2$ of negative refractive power. The second lens group $G_2$ comprises a negative meniscus lens $L_{21}$ having a convex surface facing the incident side of a light beam, a biconcave negative lens $L_{22}$, and a biconvex positive lens $L_{23}$, and forms a primary image $I_1$ as a reduced image of an object between the negative lens $L_{22}$ and the positive lens $L_{23}$. The light beam emerging from the second lens group $G_2$ is deflected by a planar reflection mirror $M_4$, which is obliquely arranged at 45° with respect to an optical axis $Ax_2$ of the second lens group $G_2$, and reaches a second concave reflection mirror $M_2$ having a magnification larger than unity. The light beam reflected by the second concave reflection mirror $M_2$ is incident on a third lens group $G_3$ of positive refractive power. The third lens group $G_3$ comprises, in succession from the incident side of a light beam, a negative meniscus lens $L_{31}$ having a convex surface facing the object side, a biconvex positive lens $L_{32}$, a positive meniscus lens $L_{33}$ having a convex surface facing the incident side, a negative meniscus lens $L_{34}$ having a concave surface facing the incident side, and a biconvex positive lens $L_{35}$, and forms a secondary image $I_2$ in a larger reduction scale than that of the primary image $I_1$ at the exit side of the third lens group $G_3$.

The sixth embodiment, as well, has a reduction factor of +0.25 or 1/4 as a whole, and achieves a numerical aperture of (N.A.) of 0.45 in a ring-shaped view field centered at an arc having a radius of 24.25 mm from the optical axis.

Table 6 below shows data of the sixth embodiment.

Note that the radius of curvature of each of the first and second concave reflection mirrors $M_1$ and $M_2$ shown in Table 6 is the radius of paraxial curvature, and the non-spherical surface coefficients of these first and second reflection mirrors $M_1$ and $M_2$ are separately listed. The refractive index of each glass material corresponds to that at the wavelength (248 nm) of KrF.

Table 6

| No. | Radius of Curvature | Plane-to-Plane Distance | Refractive Index | | |
|---|---|---|---|---|---|
| | Sixth Embodiment | | | | |
| | (Object Surface) | 414.498 | 1.0000 | | |
| 1 | 8211.322 | 38.636 | 1.508385 | (quartz) | $L_{11}$ |
| 2 | -439.506 | 0.100 | 1.0000 | | |
| 3 | 239.531 | 74.172 | 1.508385 | (quartz) | $L_{12}$ |
| 4 | 1059.356 | 0.100 | 1.0000 | | |
| 5 | 220.874 | 71.349 | 1.508385 | (quartz) | $L_{13}$ |
| 6 | 192.087 | 28.244 | 1.0000 | | |
| 7 | 9114.936 | 13.285 | 1.508385 | (quartz) | $L_{14}$ |
| 8 | 135.907 | 347.569 | 1.0000 | | |
| 9 | -236.652 | 19.683 | 1.508385 | (quartz) | $G_5$ |
| 10 | -287.731 | 551.277 | 1.0000 | | |
| 11 | -1024.933 | -551.277 | -1.0000 | (non-spherical) | $M_1$ |
| 12 | -287.731 | -19.683 | -1.508385 | (quartz) | $G_5$ |
| 13 | -236.652 | -314.837 | -1.0000 | | |
| 14 | -149.845 | -31.308 | -1.508385 | (quartz) | $L_{21}$ |
| 15 | -137.269 | -33.137 | -1.0000 | | |
| 16 | 257.207 | -10.000 | -1.508385 | (quartz) | $L_{22}$ |
| 17 | -315.674 | -37.792 | -1.0000 | | |
| 18 | -459.634 | -27.954 | -1.508385 | (quartz) | $L_{23}$ |
| 19 | 431.125 | -848.560 | -1.0000 | | |
| 20 | 1044.120 | 752.496 | 1.0000 | (non-spherical) | $M_2$ |
| 21 | 106.792 | 12.000 | 1.508385 | (quartz) | $L_{31}$ |
| 22 | 105.550 | 24.044 | 1.0000 | | |
| 23 | 344.933 | 16.641 | 1.508385 | (quartz) | $L_{32}$ |
| 24 | -1397.225 | 0.100 | 1.0000 | | |
| 25 | 105.435 | 30.284 | 1.508385 | (quartz) | $L_{33}$ |

Table 6   (continued)

| Sixth Embodiment | | | | |
|---|---|---|---|---|
| No. | Radius of Curvature | Plane-to-Plane Distance | Refractive Index | | |
| 26 | 890.603 | 8.066 | 1.0000 | | |
| 27 | -297.345 | 32.551 | 1.508385 | (quartz) | $L_{34}$ |
| 28 | -486.516 | 1.643 | 1.0000 | | |
| 29 | 154.666 | 44.945 | 1.508385 | (quartz) | $L_{35}$ |
| 30 | -706.316 | 24.770 | 1.0000 | | |
| 31 | (Image Surface) | | | | |

<Non-spherical Surface Coefficient>

11th surface (first concave reflection mirror $M_1$)

$\kappa$     1.0
$C_4$     $-0.395493 \times 10^{-12}$
$C_6$     $-0.168923 \times 10^{-16}$
$C_8$     $-0.338178 \times 10^{-22}$
$C_{10}$     $-0.134005 \times 10^{-26}$

20th surface (second concave reflection mirror $M_2$)

$\kappa$     1.0
$C_4$     $0.340990 \times 10^{-10}$
$C_6$     $0.116056 \times 10^{-15}$
$C_8$     $0.245212 \times 10^{-21}$
$C_{10}$     $0.260273 \times 10^{-26}$

<Condition Corresponding Values>

$\beta_{G3} =$     0.238
$\beta_{M1} =$     -0.800
$\beta_{M2} =$     -1.357

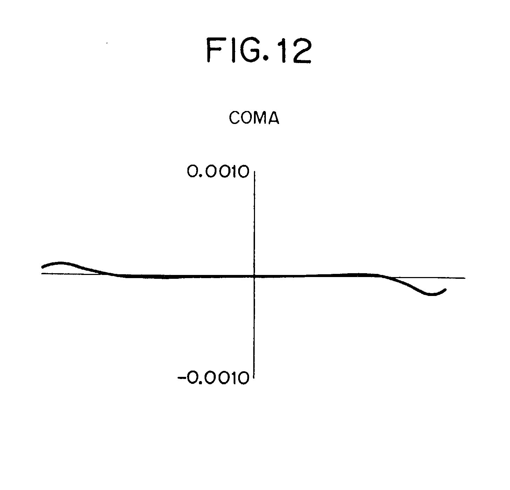

Fig. 12 shows coma of the sixth embodiment. Fig. 12 shows coma in the meridional direction at the center of the ring-shaped view field. As can be seen from Fig. 12, the sixth embodiment maintains an excellent imaging performance.

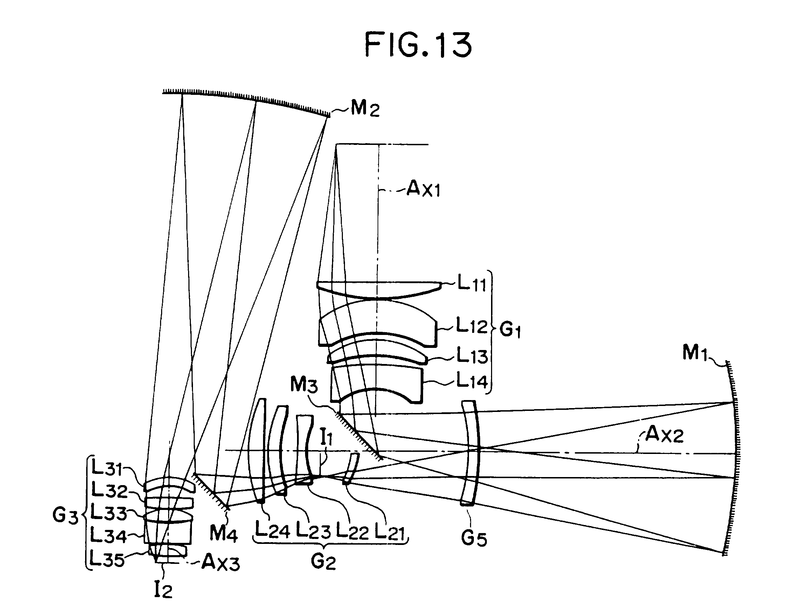

A seventh embodiment of the present invention will be described below with reference to Fig. 13. Referring to Fig. 13, a light beam from the object surface emerges from a first lens group $G_1$ which comprises a biconvex positive lens $L_{11}$, a positive meniscus lens $L_{12}$ having a convex surface facing the incident side of a light beam, a positive meniscus lens $L_{13}$ having a convex surface facing the incident side of a light beam, and a negative meniscus lens $L_{14}$ having a convex surface facing the incident side, and has positive refractive power as a whole, and is deflected by a planar reflection mirror $M_3$ which is obliquely arranged at 45° with respect to an optical axis $Ax_1$ of the first lens group $G_1$. The deflected light beam reaches a first concave reflection mirror $M_1$ having a magnification slightly smaller than unity via a fifth lens group $G_5$ of negative refractive power. The fifth lens group $G_5$ comprises a negative meniscus lens having a convex surface facing the first concave reflection mirror $M_1$. The light beam reflected by the first concave reflection mirror $M_1$ is incident on a second lens group $G_2$ of negative refractive power via the second lens group $G_5$ again. The second lens group $G_2$ comprises a negative meniscus lens $L_{21}$ having a convex surface facing the incident side of a light beam, a biconcave negative lens $L_{22}$, a positive meniscus lens $L_{23}$ having a concave surface facing the incident side, and a positive meniscus lens $L_{24}$ having a concave surface facing the incident side, and forms a primary image $I_1$ as a reduced image of an object in the optical path between the negative lenses $L_{21}$ and $L_{22}$. Note that the negative lens $L_{21}$ in the second lens group is arranged at only one side of the optical axis $Ax_2$ so as not to shield the optical path extending from the first lens group $G_1$ toward the first concave reflection mirror $M_1$.

The light beam emerging from the second lens group $G_2$ is deflected by a planar reflection mirror $M_4$ which is obliquely arranged at 45° with respect to the optical axis $Ax_2$ of the second lens group $G_2$, is reflected by a second concave reflection mirror $M_2$ having a magnification larger than unity, and then becomes incident on a third lens group

$G_3$ of positive refractive power. The third lens group $G_3$ comprises a negative meniscus lens $L_{31}$ having a convex surface facing the incident side of a light beam, a biconvex positive lens $L_{32}$, a positive meniscus lens $L_{33}$ having a convex surface facing the incident side, a biconcave negative lens $L_{34}$, and a biconvex positive lens $L_{35}$, and forms a secondary image $I_2$ in a larger reduction scale than that of the primary image $I_1$.

The seventh embodiment has a reduction factor of +0.25 or 1/4 as a whole, and achieves a numerical aperture of (N.A.) of 0.4 in a ring-shaped view field centered at an arc having a radius of 25 mm from the optical axis.

Table 7 below shows data of the seventh embodiment.

In Table 7, the refractive index of each glass material corresponds to that at the wavelength (193 nm) of ArF.

Table 7

| No. | Radius of Curvature | Plane-to-Plane Distance | Refractive Index | | |
|---|---|---|---|---|---|
| | | Seventh Embodiment | | | |
| | (Object Surface) | 298.019 | 1.0000 | | |
| 1 | 4860.661 | 33.000 | 1.501375 | (fluorite) | $L_{11}$ |
| 2 | -410.727 | 0.100 | 1.0000 | | |
| 3 | 202.797 | 73.000 | 1.501375 | (fluorite) | $L_{12}$ |
| 4 | 221.645 | 12.851 | 1.0000 | | |
| 5 | 189.285 | 33.370 | 1.501375 | (fluorite) | $L_{13}$ |
| 6 | 308.080 | 19.873 | 1.0000 | | |
| 7 | 942.449 | 50.409 | 1.560194 | (quartz) | $L_{14}$ |
| 8 | 133.378 | 326.305 | 1.0000 | | |
| 9 | -409.199 | 21.087 | 1.501375 | (fluorite) | $G_5$ |
| 10 | -618.117 | 538.975 | 1.0000 | | |
| 11 | -918.138 | -538.975 | -1.0000 | | $M_1$ |
| 12 | -618.117 | -21.087 | -1.501375 | (fluorite) | $G_5$ |
| 13 | -409.199 | -230.534 | -1.0000 | | |
| 14 | -124.583 | -16.666 | -1.501375 | (fluorite) | $L_{21}$ |
| 15 | -122.761 | -99.533 | -1.0000 | | |
| 16 | 139.122 | -17.104 | -1.501375 | (fluorite) | $L_{22}$ |
| 17 | -708.717 | -35.132 | -1.0000 | | |
| 18 | 253.980 | -28.131 | -1.501375 | (fluorite) | $L_{23}$ |
| 19 | 225.928 | -6.072 | -1.0000 | | |
| 20 | 14003.190 | -33.317 | -1.560194 | (quartz) | $L_{24}$ |
| 21 | 290.144 | -904.186 | -1.0000 | | |
| 22 | 1085.235 | 804.185 | 1.0000 | | $M_2$ |
| 23 | 95.505 | 18.738 | 1.560194 | (quartz) | $L_{31}$ |
| 24 | 92.560 | 23.254 | 1.0000 | | |
| 25 | 1178.101 | 22.112 | 1.501375 | (fluorite) | $L_{32}$ |
| 26 | -788.023 | 0.100 | 1.0000 | | |
| 27 | 86.141 | 27.769 | 1.501375 | (fluorite) | $L_{33}$ |
| 28 | 734.979 | 1.972 | 1.0000 | | |
| 29 | -322.980 | 43.543 | 1.560194 | (quartz) | $L_{34}$ |
| 30 | 926.558 | 0.100 | 1.0000 | | |
| 31 | 125.704 | 23.783 | 1.501375 | (fluorite) | $L_{35}$ |
| 32 | -725.241 | 15.000 | 1.0000 | | |
| 33 | (Image Surface) | | | | |

<Condition Corresponding Values>

$\beta_{G3}$ =   0.373
$\beta_{M1}$ =   -0.814
$\beta_{M2}$ =   -0.993

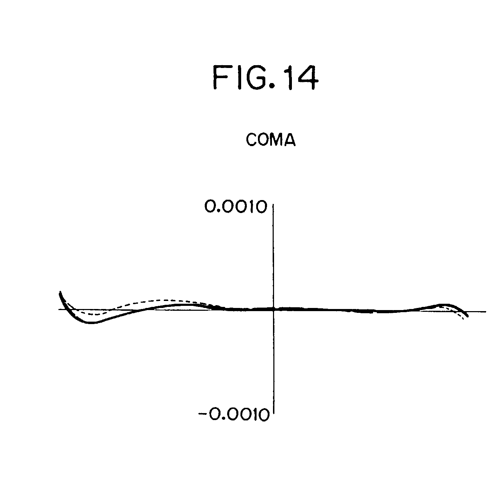

Fig. 14 shows coma of the seventh embodiment. Fig. 14 shows coma in the meridional direction at the center of the ring-shaped view field. Note that a solid curve in Fig. 14 represents coma at 193.3 nm, a broken curve represents coma at 193.7 nm, and a dotted curve represents coma at 192.9 nm. As can be seen from Fig. 14, the seventh embodiment can achieve correction of chromatic aberration within a range of ±0.4 nm at the wavelength of ArF, and maintains an excellent imaging performance.

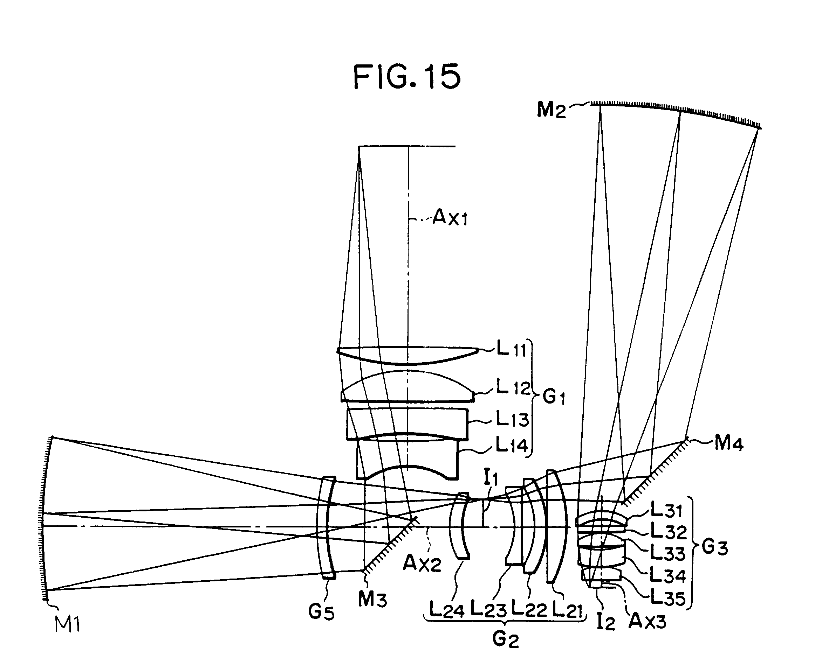

An eighth embodiment of the present invention will be described below with reference to Fig. 15. Referring to Fig. 15, a light beam from the object surface passes through a first lens group $G_1$ which comprises a biconvex positive lens $L_{11}$, a biconvex positive lens $L_{12}$, a negative meniscus lens $L_{13}$ having a convex surface facing the incident side of a light beam, and a biconcave negative lens $L_{14}$, and which has positive refractive power as a whole, and is then deflected by a planar reflection mirror $M_3$ which is obliquely arranged at 45° with respect to an optical axis $Ax_1$ of the first lens group $G_1$. The deflected light beam reaches a first concave reflection mirror $M_1$ having a magnification slightly smaller than unity via a fifth lens group $G_5$ of negative refractive power. The fifth lens group $G_5$ comprises a negative meniscus lens having a convex surface facing the first concave reflection mirror $M_1$ side. The light beam reflected by the first concave reflection mirror $M_1$ is incident on a second lens group $G_2$ of negative refractive power via the fifth lens group $G_5$ again. The second lens group $G_2$ comprises a negative meniscus lens $L_{21}$ having a convex surface facing the incident side of a light beam, a negative meniscus lens $L_{22}$ having a concave surface facing the incident side, a negative meniscus lens $L_{23}$ having a concave surface facing the incident side, and a biconvex positive lens $L_{24}$, and forms a primary reduced image $I_1$ between the negative lenses $L_{21}$ and $L_{22}$.

The light beam emerging from the second lens group $G_2$ is deflected by a planar reflection mirror $M_4$ which is obliquely arranged at 45° with respect to an optical axis $Ax_2$ of the second lens group $G_2$, is reflected by a second concave reflection mirror $M_2$ having a magnification larger than unity, and then becomes incident on a third lens group $G_3$ of positive refractive power. The third lens group $G_3$ comprises a negative meniscus lens $L_{31}$ having a convex surface facing the incident side of a light beam, a biconvex positive lens $L_{32}$, a biconvex positive lens $L_{33}$, a negative meniscus lens $L_{34}$ having a concave surface facing the incident side, and a positive meniscus lens $L_{35}$ having a convex surface facing the incident side, and forms a secondary image $I_2$ in a larger reduction scale than that of the primary image $I_1$ at its exit side.

The eighth embodiment has a reduction factor of +0.25 or 1/4 as a whole, and achieves a numerical aperture of (N.A.) of 0.4 in a ring-shaped view field centered at an arc having a radius of 24.25 mm from the optical axis.

Table 8 below shows data of the eighth embodiment.

In Table 8, the refractive index of each glass material corresponds to that at the wavelength (248 nm) of KrF.

Table 8

| No. | Radius of Curvature | Plane-to-Plane Distance | Refractive Index | | |
|---|---|---|---|---|---|
| | (Object Surface) | 400.975 | 1.0000 | | |
| 1 | 3191.354 | 33.000 | 1.508385 | (quartz) | $L_{11}$ |
| 2 | -448.984 | 15.428 | 1.0000 | | |
| 3 | 223.181 | 64.645 | 1.508385 | (quartz) | $L_{12}$ |
| 4 | -4151.509 | 12.219 | 1.0000 | | |
| 5 | 11253.765 | 49.299 | 1.508385 | (quartz) | $L_{13}$ |
| 6 | 461.799 | 16.133 | 1.0000 | | |
| 7 | -1336.016 | 48.239 | 1.508385 | (quartz) | $L_{14}$ |
| 8 | 158.062 | 281.551 | 1.0000 | | |
| 9 | -312.940 | 20.065 | 1.508385 | (quartz) | $G_5$ |
| 10 | -441.735 | 538.318 | 1.0000 | | |
| 11 | -919.752 | -538.318 | -1.0000 | | $M_1$ |
| 12 | -441.735 | -20.065 | -1.508385 | (quartz) | $G_5$ |
| 13 | -312.940 | -247.755 | -1.0000 | | |
| 14 | -132.399 | -22.942 | -1.508385 | (quartz) | $L_{21}$ |
| 15 | -127.754 | -104.702 | -1.0000 | | |
| 16 | 134.695 | -14.420 | -1.508385 | (quartz) | $L_{22}$ |
| 17 | 11180.397 | -23.490 | -1.0000 | | |
| 18 | 160.735 | -29.211 | -1.508385 | (quartz) | $L_{23}$ |
| 19 | 163.686 | -0.100 | -1.0000 | | |

EP 0 604 093 B1

Table 8 (continued)

| No. | Radius of Curvature | Plane-to-Plane Distance | Refractive Index | | |
|---|---|---|---|---|---|
| | | Eighth Embodiment | | | |
| 20 | 1939.060 | -37.447 | -1.508385 | (quartz) | $L_{24}$ |
| 21 | 239.738 | -905.619 | -1.0000 | | |
| 22 | 1073.545 | 806.574 | 1.0000 | | $M_2$ |
| 23 | 89.424 | 16.314 | 1.508385 | (quartz) | $L_{31}$ |
| 24 | 82.394 | 13.739 | 1.0000 | | |
| 25 | 612.232 | 15.000 | 1.508385 | (quartz) | $L_{32}$ |
| 26 | -1320.781 | 0.100 | 1.0000 | | |
| 27 | 86.666 | 25.509 | 1.508385 | (quartz) | $L_{33}$ |
| 28 | -1224.142 | 4.770 | 1.0000 | | |
| 29 | -224.139 | 36.310 | 1.508385 | (quartz) | $L_{34}$ |
| 30 | -236.345 | 0.589 | 1.0000 | | |
| 31 | 165.225 | 24.171 | 1.508385 | (quartz) | $L_{35}$ |
| 32 | 43423.922 | 15.000 | 1.0000 | | |
| 33 | (Image Surface) | | | | |

<Condition Corresponding Values>

$\beta_{G3} =$    0.400
$\beta_{M1} =$    -0.797
$\beta_{M2} =$    -0.934

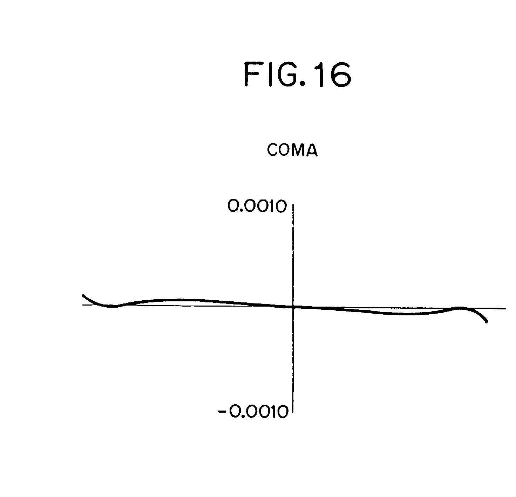

Fig. 16 shows coma of the eighth embodiment. Fig. 16 shows coma in the meridional direction at the center of the ring-shaped view field. As can be seen from Fig. 16, the eighth embodiment maintains an excellent imaging performance.

In each of the above embodiments, the primary image formed by the first partial optical system (the first lens group $G_1$ and the first concave reflection mirror $M_1$) is a reduced image. However, the primary image formed by the first partial optical system is not limited to a reduced image.

In each of the above embodiments, since the optical system is constituted to satisfy the above-mentioned conditions, the optical members constituting the catadioptric reduction projection optical system do not interfere with each other. Therefore, a physically constructible catadioptric reduction projection optical system can be obtained.

In each of the second to eighth embodiments, the object surface is set to be parallel to the image surface using the two planar reflection mirrors. Thus, when the catadioptric reduction projection optical system of each of the second to eighth embodiments is adopted as an optical system of a scanning exposure apparatus, a convey mechanism for executing scanning exposure can be simplified.

The above embodiments have been described only to clarify the technical contents of the present invention, and must not be construed to limit the scope of the present invention. Therefore, various changes and modifications may be made without departing from the scope of the invention.

**Claims**

1. A catadioptric reduction projection optical system comprising:

   a first sub-system for forming a primary image ($I_1$) of an object and including, in succession from an object side, a first lens group ($G_1$) of positive refractive power and a first concave reflection mirror ($M_1$); and
   a second sub-system for re-imaging the primary image and including, in succession from the object side, a second lens group ($G_2$) of positive or negative refractive power, a second concave reflection mirror ($M_2$) and a third lens group ($G_3$) of positive refractive power,
   wherein a magnification $\beta_{G3}$ of said third lens group ($G_3$) satisfies:

$$0.05 < \beta_{G3} < 0.6,$$

17

and
wherein a magnification $\beta_{M1}$ of said first concave reflection mirror ($M_1$) satisfies:

$$\beta_{M1} < -0.7$$

2. A system according to claim 1, wherein the magnification $\beta_{M1}$ of said first concave reflection mirror ($M_1$) satisfies:

$$-2.0 < \beta_{M1}$$

3. A system according to claim 1 or 2, wherein a magnification $\beta_{M2}$ of said second concave reflection mirror ($M_2$) satisfies:

$$-2.5 < \beta_{M2} < -0.7$$

4. A system according to claim 1, 2 or 3, wherein said first sub-system forms a reduced image ($I_1$) of the object.

5. A system according to any of claims 1 to 4, wherein said second lens group ($G_2$) is constituted to direct a light from a position substantially on an optical axis of said first concave reflection mirror ($M_1$) to a position substantially on an optical axis of said second concave reflection mirror ($M_2$).

6. A system according to any of claims 1 to 5, further comprising:
a provisional lens group ($G_4$, $G_5$) arranged in the vicinity of at least one of said first and second concave reflection mirrors ($M_1$, $M_2$).

7. A system according to claim 6, wherein said provisional lens group ($G_4$, $G_5$) has a function of correcting an aberration generated by the concave reflection mirror ($M_1$, $M_2$).

8. A system according to claim 7, wherein said provisional lens group ($G_4$, $G_5$) includes a meniscus lens component having a convex surface facing the concave reflection mirror ($M_1$, $M_2$).

9. A system according to any of claims 1 to 8, wherein a negative Petzval sum generated by said first and second concave reflection mirrors ($M_1$, $M_2$) is corrected by a positive Petzval sum generated by said third lens group ($G_3$).

10. A system according to any of claims 1 to 9, wherein at least one of said first and second concave reflection mirrors ($M_1$, $M_2$) has a non-spherical reflection surface.

11. A system according to any of claims 1 to 10, wherein at least one of said first to third lens groups ($G_1$, $G_2$, $G_3$) consists of at least two different glass materials thereby correcting chromatic aberration.

12. A system according to claim 11, wherein the at least two different glass materials include quartz glass and fluorite.

13. A system according to claim 12, wherein said first to third lens groups ($G_1$, $G_2$, $G_3$) consist of quartz glass and fluorite.

14. A system according to any of claims 1 to 10, wherein said first to third lens groups ($G_1$, $G_2$, $G_3$) consist of at least one of quartz glass and fluorite.

15. A system according to claim 14, wherein said first to third lens groups ($G_1$, $G_3$) consist of quartz glass.

16. A system according to any of claims 1 to 15, further comprising:
at least two planar reflection mirrors ($M_3$, $M_4$), which make an image surface ($I_2$) parallel to an object surface.

17. A system according to claim 16, wherein one of said at least two planar mirrors ($M_3$) is arranged in an optical path between the object surface and the primary image ($I_1$), and
the planar reflection mirror ($M_4$) different from said one planar reflection mirror ($M_3$) is arranged in an optical path between the primary image ($I_1$) and the image surface ($I_2$).

18. A system according to any of claims 1 to 17, wherein said first lens group ($G_1$) includes, in succession from the object side, a lens component ($L_{11}$, $L_{12}$, $L_{13}$) of positive refractive power, and a lens component ($L_{13}$, $L_{14}$) of negative refractive power.

19. A system according to claim 18, wherein said lens component ($L_{11}$) of the positive refractive power, which component is arranged closest to the object side, is constituted so that a concave lens surface faces the object surface side.

20. A system according to any of claims 1 to 19, wherein said second lens group ($G_2$) includes, in succession from a light incidence side, a lens component ($L_{21}$, $L_{22}$, $L_{23}$) of negative refractive power and a lens component ($L_{23}$, $L_{24}$) of positive refractive power.

21. A system according to any of claims 1 to 20, wherein said third lens group ($G_3$) includes, in succession from a light incidence side, a negative lens component ($L_{31}$, $L_{32}$), a positive lens component ($L_{32}$, $L_{33}$, $L_{34}$, $L_{35}$), a negative lens component ($L_{34}$, $L_{36}$), and a positive lens component ($L_{35}$, $L_{36}$, $L_{37}$).

22. A system according to claim 21, wherein said positive lens component ($L_{32}$) located closest to the object side in said third lens group ($G_3$) has a convex lens surface facing the light incidence side.

23. A system according to claim 1, wherein at least one of said first and second lens groups ($G_1$, $G_2$) is arranged on one side of an optical axis.

24. A system according to claim 1 having a ring-shaped view field.

**Patentansprüche**

1. Verkleinerndes katadioptrisches Projektionssystem, umfassend:

   - ein erstes Subsystem zum Bilden eines Primärbildes ($I_1$) eines Objekts und - von der Objektseite hintereinander - umfassend eine erste Linsengruppe ($G_1$) mit positiver Brechkraft und einen ersten konkaven Reflexionsspiegel ($M_1$); und
   - ein zweites Subsystem zur Neuabbildung des Primärbildes, und - von der Objektseite her aufeinanderfolgend - umfassend eine zweite Linsengruppe ($G_2$) positiver oder negativer Brechkraft, einen zweiten konkaven Reflexionsspiegel ($M_2$) und eine dritte Linsengruppe ($G_3$) positiver Brechkraft,

   wobei die Vergrößerung $\beta_{G3}$ der dritten Linsengruppe ($G_3$) der Bedingung genügt:

   $$0{,}05 < \beta_{G3} < 0{,}6,$$

   und
   wobei die Vergrößerung $\beta_{M1}$ des ersten konkaven Reflexionsspiegels ($M_1$) die Bedingung erfüllt:

   $$\beta_{M1} < -0{,}7.$$

2. System nach Anspruch 1, bei dem die Vergrößerung $\beta_{M1}$ des ersten konkaven Reflexionsspiegels ($M_1$) die Bedingung erfüllt:

   $$-2{,}0 < \beta_{M1}.$$

3. System nach Anspruch 1 oder 2, bei dem die Vergrößerung $\beta_{M2}$ des zweiten konkaven Reflexionsspiegels ($M_2$) die Bedingung erfüllt:

$$-2,5 < \beta_{M2} < -0,7.$$

**4.** System nach Anspruch 1, 2 oder 3, bei dem

das erste Subsystem ein verkleinertes Bild ($I_1$) des Objekts erzeugt.

**5.** System nach einem der Ansprüche 1 bis 4, bei dem
die zweite Linsengruppe ($G_2$) derart ausgebildet ist, daß sie Licht von einer im wesentlichen auf der optischen Achse des ersten konkaven Reflexionsspiegels ($M_1$) liegenden Stelle auf eine Stelle lenkt, die sich im wesentlichen auf der optischen Achse des zweiten konkaven Reflexionsspiegels ($M_2$) befindet.

**6.** System nach einem der Ansprüche 1 bis 5, weiterhin umfassend:

- eine Hilfs-Linsengruppe ($G_4$, $G_5$), die in der Nähe mindestens eines der beiden konkaven Reflexionsspiegel ($M_1$, $M_2$) angeordnet ist.

**7.** System nach Anspruch 6, bei dem
die Hilfs-Linsengruppe ($G_4$, $G_5$) die Funktion hat, eine von dem konkaven Reflexionsspiegel ($M_1$, $M_2$) hervorgerufene Aberration zu korrigieren.

**8.** System nach Anspruch 7, bei dem
die Hilfs-Linsengruppe ($G_4$, $G_5$) eine Meniskuslinsenkomponente mit einer dem konkaven Reflexionsspiegel ($M_1$, $M_2$) zugewandten konvexen Fläche enthält.

**9.** System nach einem der Ansprüche 1 bis 8, bei dem
die vom ersten und zweiten konkaven Reflexionsspiegel ($M_1$, $M_2$) gebildete negative Petzval-Summe korrigiert wird durch eine positive Petzval-Summe, die von der dritten Linsengruppe ($G_3$) erzeugt wird.

**10.** System nach einem der Ansprüche 1 bis 9, bei dem
zumindest einer von erstem und zweitem konkavem Reflexionsspiegel ($M_1$, $M_2$) eine asphärische Reflexionsfläche besitzt.

**11.** System nach einem der Ansprüche 1 bis 10, bei dem
zumindest eine der ersten bis dritten Linsengruppe ($G_1$, $G_2$, $G_3$) aus mindestens zwei unterschiedlichen Glasmaterialien besteht, um dadurch chromatische Aberration zu korrigieren.

**12.** System nach Anspruch 11, bei dem
die mindestens zwei verschiedenen Glasmaterialien Quarzglas und Fluorid enthalten.

**13.** System nach Anspruch 12, bei dem
die erste bis dritte Linsengruppe ($G_1$, $G_2$, $G_3$) aus Quarzglas und Fluorid bestehen.

**14.** System nach einem der Ansprüche 1 bis 10, bei dem
die erste bis dritte Linsengruppe ($G_1$, $G_2$, $G_3$) aus zumindest einem der Materialien Quarzglas und Fluorid bestehen.

**15.** System nach Anspruch 14, bei dem
die erste bis dritte Linsengruppe ($G_1$, $G_3$) aus Quarzglas bestehen.

**16.** System nach einem der Ansprüche 1 bis 15, weiterhin umfassend:

- mindestens zwei planare Reflexionsspiegel ($M_3$, $M_4$), die eine Bildfläche ($I_2$) parallel zu einer Objektfläche machen.

**17.** System nach Anspruch 16, bei dem

- einer ($M_3$) der planaren Reflexionsspiegel im optischen Weg zwischen Objektfläche und Primärbild ($I_1$) angeordnet ist, und
- ein anderer ($M_4$) der planaren Reflexionsspiegel im optischen Weg zwischen Primärbild ($I_1$) und Bildfläche

(I$_2$) angeordnet ist.

**18.** System nach einem der Ansprüche 1 bis 17, bei dem
die erste Linsengruppe (G$_1$) - von der Objektseite her hintereinander - eine Linsenkomponente (L$_{11}$, L$_{12}$, L$_{13}$) positiver Brechkraft und eine Linsenkomponente (L$_{13}$, L$_{14}$) negativer Brechkraft beinhaltet.

**19.** System nach Anspruch 18, bei dem
die Linsenkomponente (L$_{11}$) positiver Brechkraft, welche am dichtesten auf der Objektseite angeordnet ist, eine der Objektfläche zugekehrte konkave Linsenfläche aufweist.

**20.** System nach einem der Ansprüche 1 bis 19, bei dem
die zweite Linsengruppe (G$_2$) - nacheinander von de Lichteinfallseite her - eine Linsenkomponente (L$_{21}$, L$_{22}$, L$_{23}$) negativer Brechkraft und eine Linsenkomponente (L$_{23}$, L$_{24}$) positiver Brechkraft enthält.

**21.** System nach einem der Ansprüche 1 bis 20, bei dem
die dritte Linsengruppe (G$_3$) - nacheinander von der Lichteinfallseite her - eine negative Linsenkomponente (L$_{31}$, L$_{32}$), eine positive Linsenkomponente (L$_{32}$, L$_{33}$, L$_{34}$, L$_{35}$), eine negative Linsenkomponente (L$_{34}$, L$_{36}$) und eine positive Linsenkomponente (L$_{35}$, L$_{36}$, L$_{37}$) enthält.

**22.** System nach Anspruch 21, bei dem
die positive Linsenkomponente (L$_{32}$), die sich innerhalb der dritten Linsengruppe (G$_3$) am dichtesten an der Objektseite befindet, eine konvexe Linsenfläche aufweist, die der Lichteinfallseite zugewandt ist.

**23.** System nach Anspruch 1, bei dem
zumindest einer der ersten und der zweiten Linsengruppe (G$_1$, G$_2$) auf einer Seite einer optischen Achse angeordnet ist.

**24.** System nach Anspruch 1
mit einem ringförmigen Gesichtsfeld.

## Revendications

**1.** Système optique de projection catadioptrique avec réduction comprenant :

un premier sous-système servant à former une image primaire (I$_1$) d'un objet et comprenant, successivement à partir d'un côté objet, un premier groupe de lentilles (G$_1$) possédant un pouvoir réfringent positif et un premier miroir réfléchissant concave (M$_1$) ; et
un second sous-système pour reformer l'image primaire et comprenant, successivement à partir du côté objet, un second groupe de lentilles (G$_2$) ayant un pouvoir réfringent positif ou négatif, un second miroir réfléchissant concave (M$_2$) et une troisième groupe de lentilles (G$_3$) ayant un pouvoir réfringent positif,

dans lequel un grandissement β$_{G3}$ dudit troisième groupe de lentilles (G$_3$) satisfait à :

$$0{,}05 < \beta_{G3} < 0{,}6,$$

et
et dans lequel un grandissement β$_{M1}$ dudit premier miroir réfléchissant concave (M$_1$) satisfait à :

$$\beta_{M1} < -0{,}7$$

**2.** Système selon la revendication 1, dans lequel le grandissement β$_{M1}$ dudit premier miroir réfléchissant concave (M$_1$) satisfait à :

$$-2{,}0 < \beta_{M1}$$

3. Système selon la revendication 1 ou 2, dans lequel un grandissement $\beta_{M2}$ dudit second miroir réfléchissant concave ($M_2$) satisfait :

$$-2,5 < \beta_{M2} < -0,7$$

4. Système selon la revendication 1, 2 ou 3, caractérisé en ce que ledit premier sous-système forme une image réduite ($I_1$) de l'objet.

5. Système selon l'une des revendications 1 à 4, dans lequel ledit second groupe de lentilles ($G_2$) est situé de manière à diriger une lumière depuis une position située sensiblement sur un axe optique dudit premier miroir réfléchissant concave ($M_1$) vers une position située sensiblement sur un axe optique dudit second miroir réfléchissant concave ($M_2$).

6. Système selon l'une quelconque des revendications 1 à 5, comprenant en outre :
un groupe de lentilles provisoires ($G_4$, $G_5$) disposé au voisinage d'au moins l'un desdits premier et second miroirs réfléchissants concaves ($M_1$, $M_2$).

7. Système selon la revendication 6, dans lequel le groupe de lentilles provisoires ($G_4$, $G_5$) a pour rôle de corriger une aberration produite par le miroir réfléchissant concave ($M_1$, $M_2$).

8. Système selon la revendication 7, dans lequel ledit groupe de lentilles provisoires ($G_4$, $G_5$) comprend un composant de lentille en forme de ménisque possédant une surface convexe tournée vers le miroir réfléchissant concave ($M_1$, $M_2$).

9. Système selon l'une quelconque des revendications 1 à 8, dans lequel une somme négative de Petzval produite par lesdits premier et second miroirs réfléchissants concaves ($M_1$, $M_2$) est corrigée par une somme de Petzval positive produite par ledit troisième groupe de lentilles ($G_3$).

10. Système selon l'une quelconque des revendications 1 à 9, dans lequel au moins l'un desdits premier et second miroirs réfléchissants concaves ($M_1$, $M_2$) possède une surface réfléchissante non sphérique.

11. Système selon l'une quelconque des revendications 1 à 10, dans lequel au moins l'un desdits premier à troisième groupes de lentilles ($G_1$, $G_2$, $G_3$) est constitué par au moins deux verres différents, ce qui permet de corriger une aberration chromatique.

12. Système selon la revendication 11, dans lequel les au moins deux verres différents comprennent du verre quartzeux et du verre fluoré.

13. Système selon la revendication 12, dans lequel lesdits premier à troisième groupes de lentilles ($G_1$, $G_2$, $G_3$) sont constitués par du verre quartzeux et du verre fluoré.

14. Système selon l'une quelconque des revendications 1 à 10, dans lequel lesdits premier à troisième groupes de lentilles ($G_1$, $G_2$, $G_3$) sont constitués par au moins l'un d'un verre quartzeux et d'un verre fluoré.

15. Système selon la revendication 14, dans lequel lesdits premier à troisième groupes de lentilles ($G_1$, $G_3$) sont constitués de verre quartzeux.

16. Système selon l'une quelconque des revendications 1 à 15, comprenant en outre :
au moins deux miroirs réfléchissants plans ($M_3$, $M_4$), qui forment une surface d'image ($I_2$) parallèle à une surface de l'objet.

17. Système selon la revendication 16, dans lequel l'un desdits au moins deux miroirs plans ($M_3$) est disposé dans un trajet optique entre la surface de l'objet et l'image primaire ($I_1$), et
le miroir plan réfléchissant ($M_4$) différent dudit un miroir plan réfléchissant ($M_3$) est disposé dans un trajet optique entre l'image primaire ($I_1$) et la surface ($I_2$) d'image.

18. Système selon l'une quelconque des revendications 1 à 17, dans lequel ledit premier groupe de lentilles ($G_1$)

comprend, successivement à partir du côté objet, un composant de lentille ($L_{11}$, $L_{12}$, $L_{13}$) ayant un pouvoir réfringent positif, et un composant de lentille ($L_{13}$, $L_{14}$) ayant un pouvoir réfringent négatif.

19. Système selon la revendication 21, dans lequel ledit composant de lentille ($L_{11}$) possédant le pouvoir réfringent positif, qui le plus proche du côté objet, est constitué de telle sorte qu'une surface concave de lentille est tournée vers le côté de la surface de l'objet.

20. Système selon l'une quelconque des revendications 1 à 19, dans lequel ledit second groupe de lentilles ($G_2$) comprend successivement à partir d'un côté d'incidence de la lumière, un composant de lentille ($L_{21}$, $L_{22}$, $L_{23}$) possédant un pouvoir réfringent négatif et un composant de lentille ($L_{23}$, $L_{24}$) ayant un pouvoir réfringent positif.

21. Système selon l'une quelconque des revendications 1 à 20, dans lequel ledit troisième groupe de lentilles ($G_3$) comprend, successivement à partir d'un côté d'incidence de la lumière, un composant de lentille négatif ($L_{31}$, $L_{32}$), un composant de lentille positif ($L_{32}$, $L_{33}$, $L_{34}$, $L_{35}$), un composant de lentille négatif ($L_{34}$, $L_{36}$) et une composant de lentille positif ($L_{35}$, $L_{36}$, $L_{37}$).

22. Système selon la revendication 21, dans lequel ledit composant de lentille positif ($L_{32}$), qui est situé le plus près du côté objet dans ledit troisième groupe de lentilles ($G_3$), possède une surface de lentille convexe tournée le côté d'incidence de la lumière.

23. Système selon la revendication 1, dans lequel au moins l'un desdits premier et second groupes de lentilles ($G_1$, $G_2$) est disposé d'un côté d'un axe optique.

24. Système selon la revendication 1, possédant un champ d'observation de forme annulaire.

# FIG.1

# FIG. 2

COMA

# FIG. 3

# FIG. 4

COMA

# FIG. 5

# FIG. 6

COMA

# FIG. 7

EP 0 604 093 B1

# FIG. 8

COMA

# FIG. 9

# FIG. 10

COMA

0.0010

-0.0010

# FIG.11

# FIG.12

COMA

# FIG.13

EP 0 604 093 B1

# FIG. 14

COMA

FIG.15

EP 0 604 093 B1

# FIG.16

COMA